# EUROPEAN PATENT APPLICATION

(11) **EP 4 848 629 A1**
(43) Date of publication of application: **02.12.2026**
(21) Application number: 25751188.1
(22) Date of filing: 21.01.2025
(51) Int. Cl.: H04L 1/00

(54) **COMMUNICATION METHOD AND RELATED APPARATUS**

(30) Priority: 08.02.2024 CN 202410178336
(71) Applicant: Huawei Technologies Co., Ltd., Shenzhen, Guangdong 518129 (CN)
(72) Inventor: DONG, Pengpeng, Shenzhen, Guangdong 518129 (CN); FANG, Zequn, Shenzhen, Guangdong 518129 (CN); ZHENG, Chen, Shenzhen, Guangdong 518129 (CN)
(74) Representative: Pfenning, Meinig & Partner mbB
(86) International application number: PCT/CN2025/073650
(87) International publication number: WO 2025/167586

(57) **Abstract**

This application provides a communication method and a related apparatus. The method includes: determining a redundancy version RV corresponding to an encoded bit sequence, where the encoded bit sequence includes a plurality of bit segments, each of the plurality of bit segments includes a system bit, and a start location corresponding to the RV is located in one of the plurality of bit segments; and performing data transmission based on the RV. According to embodiments of this application, the start location corresponding to the RV is located in the one of the plurality of bit segments, and each bit segment corresponds to a group of system bits. In this way, data transmission based on each RV is associated with the group of system bits, thereby ensuring data transmission efficiency and data retransmission performance.

## Description

This application claims priority to Chinese Patent Application No. 202410178336.0, filed with the China National Intellectual Property Administration on February 8, 2024 and entitled "COMMUNICATION METHOD AND RELATED APPARATUS", which is incorporated herein by reference in its entirety.

### TECHNICAL FIELD

This application relates to the field of wireless communication technologies, and in particular, to a communication method and a related apparatus.

### BACKGROUND

A spatially coupled code is a capacity-approaching coding scheme. The spatially coupled code may be used to construct a new codeword by using conventional codes such as a low density parity check (low density parity check, LDPC) code, a Reed-Solomon (Reed-Solomon, RS) code, and a Bose-Chaudhuri-Hocquenghem (Bose-Chaudhuri-Hocquenghem, BCH) code as component codes for operations such as convolution and superposition. A spatially coupled LDPC (Spatially Coupled LPDC, SC-LDPC) code is a constructable code proposed on the basis of the LDPC code. In comparison with the LDPC code, the SC-LDPC code has better decoding performance and a simple encoding structure. In theory, the SC-LDPC code can approach the Shannon limit, and a unique syndrome forward encoding scheme and a unique sliding window decoding scheme are used. This effectively reduces encoding and decoding complexity. However, the SC-LDPC code is similar to a product code. Because a large quantity of component codes are split, code lengths of the component codes are short, and code rate adaptation of the SC-LDPC code is difficult to design. Therefore, currently, the SC-LDPC code is mainly applied to fields such as storage and optical communication.

A conventional technology solution provides a redundancy version (redundancy version, RV) partitioning method for a new radio (new radio, NR) LDPC code, and has good retransmission performance for a check matrix of the single LDPC code. However, the conventional technology solution does not provide an RV partitioning design based on structural codes of a plurality of component codes.

### SUMMARY

Embodiments of this application provide a communication method and a related apparatus, to transmit data based on a redundancy version RV corresponding to an encoded bit sequence. A start location corresponding to the RV is located in one of a plurality of bit segments included in the encoded bit sequence, and each bit segment corresponds to a group of system bits. In this way, data transmission based on each RV is associated with the group of system bits, thereby ensuring data transmission efficiency and data retransmission performance.

According to a first aspect, this application provides a communication method, applied to a first device. The first device may be a network device or a component (for example, a chip or a circuit) that may be applied to a network device, or may be a terminal device or a component (for example, a chip or a circuit (for example, a modem (modem) chip, also referred to as a baseband (baseband) chip, or a system on chip (System on Chip, SoC) or a system in package (System in Package, SIP) that includes a modem core)) that may be applied to a terminal device. The method includes: determining a redundancy version RV corresponding to an encoded bit sequence, where the encoded bit sequence includes a plurality of bit segments, each of the plurality of bit segments includes a system bit, and a start location corresponding to the RV is located in one of the plurality of bit segments; and performing data transmission based on the RV.

In embodiments of this application, the start location corresponding to the RV is located in the one of the plurality of bit segments, so that each group of system bits is associated with at least one RV. In this way, each group of system bits can be transmitted through data transmission performed by a transmit end based on the RV, so that a receive end decodes each group of system bits to obtain the group of system bits, thereby effectively improving data transmission efficiency or spectral efficiency.

In some possible implementations, the RV includes a first RV, the first RV uses the plurality of bit segments as a granularity, and the performing data transmission based on the RV includes: transmitting, by using a start location corresponding to the first RV as a start point, at least one bit segment corresponding to the encoded bit sequence.

In some possible implementations, the RV includes a second RV, the second RV uses each of the plurality of bit segments as a granularity, and the performing data transmission based on the RV includes: transmitting, by using a start location corresponding to the second RV as a start point, a bit segment in which the second RV is located.

In embodiments of this application, regardless of the first RV or the second RV, the start location corresponding to the RV is located in the one of the plurality of bit segments, so that each group of system bits is associated with the at least one RV, and the receive end decodes each group of system bits to obtain the group of system bits, thereby effectively improving the data transmission efficiency. However, for the second RV, the start location of data transmission can be located at the smaller granularity, so that the corresponding RV can be selected more accurately for a bit (segment) with a decoding error to perform data retransmission, thereby improving retransmission performance.

In some possible implementations, the encoded bit sequence is generated through encoding based on a globally coupled code.

In some possible implementations, the encoded bit sequence is generated by encoding a plurality of segmented bit sequences based on a plurality of first component codes respectively, and the plurality of segmented bit sequences do not overlap with each other.

In some possible implementations, the encoded bit sequence is generated through encoding based on a spatially coupled code.

In some possible implementations, the encoded bit sequence is generated by encoding a plurality of segmented bit sequences based on a plurality of second component codes respectively, and in the plurality of segmented bit sequences, a segmented bit sequence includes at least a part of system bit sequences in a previous segmented bit sequence.

In some possible implementations, all bit segments correspond to a same quantity of second RVs that is greater than 1.

In embodiments, for a globally coupled code encoding scheme, because matrices of all first component codes are not correlated, quantities of second RVs corresponding to the plurality of bit segments obtained through encoding based on the plurality of first component codes may be the same, and the quantity of second RVs is greater than 1. In this way, when data transmission is performed for each bit segment, a transmission start location can be selected for each bit segment at a same granularity. This ensures data transmission flexibility.

In some possible implementations, in the plurality of bit segments, a quantity of second RVs corresponding to an edge bit segment is greater than a quantity of second RVs corresponding to a non-edge bit segment, and the edge bit segment is a 1^{st} or last one of the plurality of bit segments.

In embodiments of this application, the plurality of bit segments obtained through encoding based on the spatially coupled code are divided into second RVs. The edge bit segment corresponds to more second RVs, and the non-edge bit segment corresponds to fewer second RVs. In this way, encoding complexity and storage overheads can be reduced while a decoding capability of the second component code is ensured.

In some possible implementations, the method further includes: receiving first information, where the first information indicates that a decoding error exists in data transmitted based on the RV; and performing data retransmission the based on the first information and a next RV.

In some possible implementations, the first information includes 1 bit, and when a value of the 1 bit is a first value, it indicates that the decoding error exists in the plurality of bit segments; or the first information includes a bitmap, and the bitmap indicates one or more bit segments in which the decoding error exists in the plurality of bit segments.

In some possible implementations, the first information includes negative acknowledgment NACK information.

In embodiments of this application, that the decoding error exists in the data transmitted based on the RV is indicated based on the first information, so that the first device determines, based on the first information, whether to retransmit the data based on the next RV. In this process, because each RV corresponds to one bit segment, each time of retransmission can correspond to at least one system bit, thereby improving the retransmission performance. However, for data retransmission of the second RV, a granularity of a retransmitted bit sequence is more accurately divided, so that resource consumption of data retransmission can be reduced while the retransmission performance is ensured.

In some possible implementations, the method further includes: receiving second information, where the second information indicates a target RV; and performing data retransmission based on the second information, the target RV, and the encoded bit sequence.

In some possible implementations, the second information is carried in downlink control information DCI.

In embodiments of this application, the first device is indicated to perform data retransmission based on the target first RV corresponding to the bit segment with a decoding error. Because each RV corresponds to one bit segment, each time of retransmission can correspond to at least one system bit, thereby improving the retransmission performance. In addition, the first device may be further indicated to perform data retransmission based on the target second RV of the bit segment with a decoding error, to indicate the first device to retransmit the bit sequence at a more accurate granularity. This reduces resource consumption of data retransmission while ensuring the retransmission performance.

In some possible implementations, data transmission corresponds to a plurality of hybrid automatic repeat request HARQ processes, and before feedback information for one HARQ process is received, a next one of the plurality of HARQ processes is started.

According to the method in embodiments of this application, concurrent transmission efficiency of the first device can be further improved.

According to a second aspect, this application provides a communication method, applied to a second device. The second device may be a network device or a component (for example, a chip or a circuit) that may be applied to a network device, or may be a terminal device or a component (for example, a chip or a circuit) that may be applied to a terminal device. The method includes: receiving data transmitted based on an RV, where a start location corresponding to the RV is located in a plurality of bit segments included in a pre-decoding bit sequence, and each bit segment includes a system bit; and sending first information or second information, where the first information indicates that a decoding error exists in the data transmitted based on the RV, and the second information indicates a target RV.

In some possible implementations, the RV includes a first RV, and the first RV uses the plurality of bit segments as a granularity.

In some possible implementations, the RV includes a second RV, and the second RV uses each of the plurality of bit segments as a granularity.

In some possible implementations, the bit sequence before decoding is generated through encoding based on a globally coupled code.

In some possible implementations, the bit sequence before decoding is generated by encoding a plurality of segmented bit sequences based on a plurality of first component codes respectively, and the plurality of segmented bit sequences do not overlap with each other.

In some possible implementations, the bit sequence before decoding is generated through encoding based on a spatially coupled code.

In some possible implementations, the bit sequence before decoding is generated by encoding a plurality of segmented bit sequences based on a plurality of second component codes respectively, and in the plurality of segmented bit sequences, a segmented bit sequence includes at least a part of system bit sequences in a previous segmented bit sequence.

In some possible implementations, all bit segments correspond to a same quantity of second RVs that is greater than 1.

In some possible implementations, in the plurality of bit segments, a quantity of second RVs corresponding to an edge bit segment is greater than a quantity of second RVs corresponding to a non-edge bit segment, and the edge bit segment is a 1^{st} or last one of the plurality of bit segments.

In some possible implementations, the first information includes negative acknowledgment NACK information.

In some possible implementations, the second information is carried in downlink control information DCI.

According to a third aspect, a communication apparatus is provided. The apparatus includes: a processing unit, configured to determine a redundancy version RV corresponding to an encoded bit sequence, where the encoded bit sequence includes a plurality of bit segments, and a start location corresponding to the RV is located in one of the plurality of bit segments; and a transceiver unit, configured to perform data transmission based on the RV.

In some possible implementations, the RV includes a first RV, the first RV uses the plurality of bit segments as a granularity, and the performing data transmission based on the RV includes: transmitting, by using a start location corresponding to the first RV as a start point, at least one bit segment corresponding to the encoded bit sequence.

In some possible implementations, the RV includes a second RV, the second RV uses each of the plurality of bit segments as a granularity, and the performing data transmission based on the RV includes: transmitting, by using a start location corresponding to the second RV as a start point, a bit segment in which the second RV is located.

In some possible implementations, the encoded bit sequence is generated through encoding based on a globally coupled code.

In some possible implementations, the encoded bit sequence is generated by encoding a plurality of segmented bit sequences based on a plurality of first component codes respectively, and the plurality of segmented bit sequences do not overlap with each other.

In some possible implementations, the encoded bit sequence is generated through encoding based on a spatially coupled code.

In some possible implementations, the encoded bit sequence is generated by encoding a plurality of segmented bit sequences based on a plurality of second component codes respectively, and in the plurality of segmented bit sequences, a segmented bit sequence includes at least a part of system bit sequences in a previous segmented bit sequence.

In some possible implementations, all bit segments correspond to a same quantity of second RVs that is greater than 1.

In some possible implementations, in the plurality of bit segments, a quantity of second RVs corresponding to an edge bit segment is greater than a quantity of second RVs corresponding to a non-edge bit segment, and the edge bit segment is a 1^{st} or last one of the plurality of bit segments.

In some possible implementations, the transceiver unit is further configured to: receive first information, where the first information indicates that a decoding error exists in data transmitted based on the RV; and perform data retransmission the based on the first information and a next RV.

In some possible implementations, the first information includes 1 bit, and when a value of the 1 bit is a first value, it indicates that the decoding error exists in the plurality of bit segments; or the first information includes a bitmap, and the bitmap indicates one or more bit segments in which the decoding error exists in the plurality of bit segments.

In some possible implementations, the first information includes negative acknowledgment NACK information.

In some possible implementations, the transceiver unit is further configured to: receive second information, where the second information indicates a target RV; and perform data retransmission based on the target RV.

In some possible implementations, the second information is carried in downlink control information DCI.

In some possible implementations, data transmission corresponds to a plurality of hybrid automatic repeat request HARQ processes, and the processing unit is further configured to: before receiving feedback information for one HARQ process, start a next one of the plurality of HARQ processes.

According to a fourth aspect, a communication apparatus is provided. The apparatus includes: a transceiver unit, configured to receive data transmitted based on an RV, where a start location corresponding to the RV is located in a plurality of bit segments included in a bit sequence before decoding, and each bit segment includes a system bit; and a processing unit, configured to send first information or second information by combining the transceiver unit, where the first information indicates that a decoding error exists in the data transmitted based on the RV, and the second information indicates a target RV.

In some possible implementations, the RV includes a first RV, and the first RV uses the plurality of bit segments as a granularity.

In some possible implementations, the RV includes a second RV, and the second RV uses each of the plurality of bit segments as a granularity.

In some possible implementations, the bit sequence before decoding is generated through encoding based on a globally coupled code.

In some possible implementations, the bit sequence before decoding is generated by encoding a plurality of segmented bit sequences based on a plurality of first component codes respectively, and the plurality of segmented bit sequences do not overlap with each other.

In some possible implementations, the bit sequence before decoding is generated through encoding based on a spatially coupled code.

In some possible implementations, the bit sequence before decoding is generated by encoding a plurality of segmented bit sequences based on a plurality of second component codes respectively, and in the plurality of segmented bit sequences, a segmented bit sequence includes at least a part of system bit sequences in a previous segmented bit sequence.

In some possible implementations, all bit segments correspond to a same quantity of second RVs that is greater than 1.

In some possible implementations, in the plurality of bit segments, a quantity of second RVs corresponding to an edge bit segment is greater than a quantity of second RVs corresponding to a non-edge bit segment, and the edge bit segment is a 1^{st} or last one of the plurality of bit segments.

In some possible implementations, the first information includes negative acknowledgment NACK information.

In some possible implementations, the second information is carried in downlink control information DCI.

According to a fifth aspect, this application provides a communication apparatus. The communication apparatus includes a processor, and the processor is coupled to a memory. When the processor executes a computer program or instructions in the memory, the method according to any one of the implementations of the first aspect or the second aspect is performed.

Optionally, the apparatus further includes the memory.

Optionally, the apparatus further includes a communication interface, and the processor is coupled to the communication interface.

Optionally, there is one or more processors, and there is one or more memories.

Optionally, the memory may be integrated with the processor, or the memory and the processor are disposed separately.

Optionally, the transceiver may include a transmitter machine (transmitter) and a receiver machine (receiver).

In an implementation, the communication apparatus is a terminal device. When the communication apparatus is the terminal device, the communication interface may be a transceiver or an input/output interface. Optionally, the transceiver may be a transceiver circuit. Optionally, the input/output interface may be an input/output circuit.

In another implementation, the communication apparatus is a chip or a chip system. When the apparatus is the chip or the chip system, the communication interface may be an input/output interface, an interface circuit, an output circuit, an input circuit, a pin, a related circuit, or the like on the chip or in the chip system. The processor may alternatively be embodied as a processing circuit or a logic circuit.

According to a sixth aspect, this application provides a communication apparatus. The communication apparatus includes a processor, and the processor is coupled to a memory. When the processor executes a computer program or instructions in the memory, the method according to any one of the implementations of the first aspect or the second aspect is performed.

Optionally, the apparatus further includes the memory.

Optionally, the apparatus further includes a communication interface, and the processor is coupled to the communication interface.

Optionally, there is one or more processors, and there is one or more memories.

Optionally, the memory may be integrated with the processor, or the memory and the processor are disposed separately.

Optionally, the transceiver may include a transmitter machine (transmitter) and a receiver machine (receiver).

In an implementation, the communication apparatus is a network device. When the communication apparatus is the network device, the communication interface may be a transceiver or an input/output interface. Optionally, the transceiver may be a transceiver circuit. Optionally, the input/output interface may be an input/output circuit.

In another implementation, the communication apparatus is a chip or a chip system. When the apparatus is the chip or the chip system, the communication interface may be an input/output interface, an interface circuit, an output circuit, an input circuit, a pin, a related circuit, or the like on the chip or in the chip system. The processor may alternatively be embodied as a processing circuit or a logic circuit.

According to a seventh aspect, this application provides a communication system. The communication system includes the communication apparatuses in the third aspect and the fourth aspect, or includes the communication apparatuses in the fifth aspect and the sixth aspect.

According to an eighth aspect, this application provides a computer program product. The computer program product includes a computer program (which may also be referred to as code or instructions). When the computer program is run, the computer is enabled to perform the method according to any one of the possible implementations of the first aspect or the second aspect.

According to a ninth aspect, this application provides a computer-readable storage medium. The computer-readable medium stores a computer program (which may also be referred to as code or instructions). When the computer program runs on a computer, the computer is enabled to perform the method according to any one of the possible implementations of the first aspect or the second aspect.

According to a tenth aspect, this application further provides a circuit, including a processor and an interface, configured to execute a computer program or instructions stored in a memory, to perform the method according to any one of the possible implementations of the first aspect or the second aspect.

### BRIEF DESCRIPTION OF DRAWINGS

FIG. 1 is a diagram of an application scenario according to an embodiment of this application;
FIG. 2A is a diagram of an RV division method for 5G NR LDPC according to an embodiment of this application;
FIG. 2B is a diagram of a spatially coupled code generator matrix according to an embodiment of this application;
FIG. 3A is a flowchart of a communication method according to an embodiment of this application;
FIG. 3B is a diagram of obtaining an encoded bit sequence through encoding according to an embodiment of this application;
FIG. 3C(a) and FIG. 3C(b) are diagrams of RVs according to an embodiment;
FIG. 3D(a) and FIG. 3D(b) are diagrams of a circular buffer according to an embodiment of this application;
FIG. 4A is a block diagram of an encoding procedure according to an embodiment of this application;
FIG. 4B is a diagram of globally coupled code encoding according to an embodiment of this application;
FIG. 5A is a diagram of spatially coupled code encoding according to an embodiment of this application;
FIG. 5B is a diagram of an RV division method for an encoded bit sequence according to an embodiment of this application;
FIG. 5C is a diagram of another RV division method for an encoded bit sequence according to an embodiment of this application;
FIG. 6A is a flowchart of another communication method according to an embodiment of this application;
FIG. 6B is a flowchart of another communication method according to an embodiment of this application;
FIG. 6C is a diagram of a process of determining a target RV according to an embodiment of this application;
FIG. 6D is a diagram of another process of determining a target RV according to an embodiment of this application;
FIG. 6E is a diagram of performing multi-process data transmission by a first device according to an embodiment of this application;
FIG. 7 is a diagram of a structure of a communication apparatus according to an embodiment of this application;
FIG. 8 is a diagram of a structure of another communication apparatus according to an embodiment of this application; and
FIG. 9 is a diagram of a hardware structure of a communication device according to an embodiment of this application.

### DESCRIPTION OF EMBODIMENTS

The following describes embodiments of this application with reference to the accompanying drawings in embodiments of this application.

In the specification, claims, and accompanying drawings of this application, the terms "first", "second", "third", "fourth" and the like are intended to distinguish between different objects but do not indicate a particular order. In addition, the terms "including" and "having" and any other variants thereof are intended to cover a non-exclusive inclusion. For example, a process, a method, a system, a product, or a device that includes a series of steps or units is not limited to the listed steps or units, but optionally further includes an unlisted step or unit, or optionally further includes another inherent step or unit of the process, the method, the product, or the device.

"Embodiments" mentioned herein mean that specific features, structures, or characteristics described in combination with embodiments may be included in at least one embodiment of this application. The phrase shown in various locations in the specification may not necessarily refer to a same embodiment, and is not an independent or optional embodiment exclusive from another embodiment. It is explicitly and implicitly understood by a person skilled in the art that embodiments described in the specification may be combined with another embodiment.

''A plurality of" refers to two or more than two. The term "and/or" describes an association relationship for describing associated objects and represents that three relationships may exist. For example, A and/or B may represent the following three cases: Only A exists, both A and B exist, and only B exists. The character "/" generally indicates an "or" relationship between the associated objects. "At least one of the following" or a similar expression thereof represents any combination of listed items. For example, at least one of A, B, and (or) C may represent the following cases: Only A exists, only B exists, only C exists, both A and B exist, both B and C exist, both A and C exist, and A, B, and C exist, where A, B, and C may be singular or plural.

An application scenario corresponding to an embodiment of this application is first described.

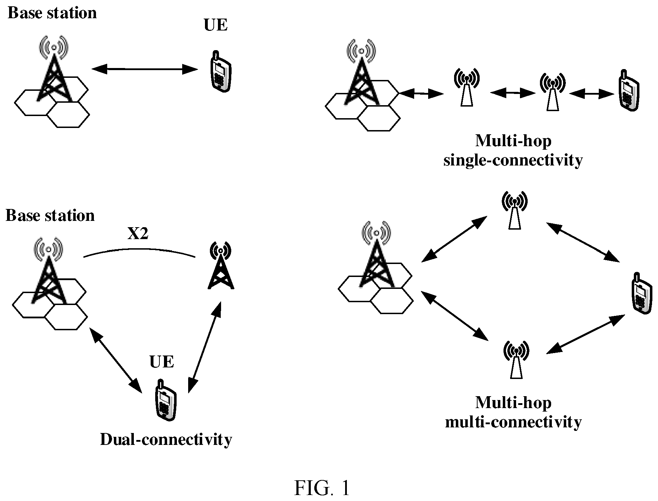

FIG. 1 is a diagram of an application scenario according to an embodiment of this application. As shown in FIG. 1, the embodiment of this application may be applied to a plurality of mobile communication scenarios, for example, a communication scenario between a base station and a user equipment (user equipment, UE), multi-hop/multi-relay (node) transmission between a base station and a UE, and dual connectivity (dual connectivity, DC) between a plurality of base stations and a UE or multi-connectivity between a UE and a plurality of relays. It should be noted that FIG. 1 is merely an example, and does not impose a limitation on a network architecture applicable to this application. Any network side device in a cellular network that can charge another device is a network architecture available to this application.

The following briefly describes terms involved in this embodiment.

A wireless communication system includes communication apparatuses, and the communication apparatuses may perform wireless communication based on an air interface resource. The communication apparatuses may include a network device and a terminal device, and the network device may also be referred to as a base station device. The air interface resource may include at least one of a time domain resource, a frequency domain resource, a code resource, and a spatial resource. In embodiments of this application, at least one may alternatively be described as one or more, and a plurality of may be two, three, four, or more. This is not limited in this application.

The terminal device in embodiments of this application may also be referred to as a terminal, and may be a device having wireless sending and receiving functions. The terminal device may be deployed on land, including an indoor device, an outdoor device, a handheld device, or a vehicle-mounted device; may be deployed on the surface of water (such as in a ship); or may be deployed in the air (such as on an airplane, a balloon, and a satellite). The terminal device may be a user equipment (user equipment, UE). The UE includes a handheld device, a vehicle-mounted device, a wearable device, or a computing device that has a wireless communication function. For example, the UE may be a mobile phone (mobile phone), a tablet computer, or a computer having wireless sending and receiving functions. Alternatively, the terminal device may be a virtual reality (virtual reality, VR) terminal device, an augmented reality (augmented reality, AR) terminal device, a wireless terminal in industrial control, a wireless terminal in self driving, a wireless terminal in telemedicine, a wireless terminal in a smart grid, a wireless terminal in a smart city (smart city), a wireless terminal in a smart home (smart home), a transport vehicle with a wireless communication function, a communication module, or the like. In embodiments of this application, an apparatus configured to implement a function of a terminal may be a terminal; or may be an apparatus, for example, a chip system, that can support the terminal in implementing the function. The apparatus may be mounted in the terminal. In embodiments of this application, the chip system may include a chip, or may include a chip and another discrete component. In some possible implementations, a communication module, a circuit, or a chip that performs a corresponding communication function is disposed in the terminal device. Program instructions used to perform a corresponding communication function may be further configured in the terminal device. In the technical solutions provided in embodiments of this application, the technical solutions provided in embodiments of this application are described by using an example in which the apparatus configured to implement the function of the terminal is a terminal and the terminal is a UE.

The network device in embodiments of this application includes an access network device, for example, a base station (base station, BS), and the BS may be a device that is deployed in a radio access network and that can perform wireless communication with the terminal. The base station may be in a plurality of forms, for example, a macro base station, a micro base station, a relay station, and an access point. For example, the base station in embodiments of this application may be a base station in 5G or an evolved NodeB (evolved NodeB, eNB) in LTE. The base station in 5G may also be referred to as a transmission reception point (transmission reception point, TRP) or a 5G NodeB (next-generation NodeB, gNB). In embodiments of this application, an apparatus configured to implement a function of the network device may be a network device; or may be an apparatus, for example, a chip system, that can support the network device in implementing the function. The apparatus may be mounted in the network device. In some possible implementations, a communication module, a circuit, or a chip that performs a corresponding communication function is disposed in the access network device. Program instructions for performing the corresponding communication function and corresponding program instructions may also be configured in the TRP. In the technical solutions provided in embodiments of this application, the technical solutions provided in embodiments of this application are described by using an example in which the apparatus configured to implement the function of the network device is a network device, and the network device is a base station.

The technical solutions provided in embodiments of this application may be applied to channel encoding/decoding between communication apparatuses. Channel encoding/decoding between the communication apparatuses may include channel encoding/decoding between a network device and a terminal, channel encoding/decoding between network devices, and channel encoding/decoding between terminals. In embodiments of this application, the term channel encoding and decoding is referred to as coding for short, and an encoding structure may be referred to as a code pattern or a code design for short. The encoding structure includes a concatenated structure, a hierarchical structure, a coupling structure, an inner- and outer-code structure, a ladder structure, a sliding window structure, and the like.

The following describes a conventional technology of an embodiment.

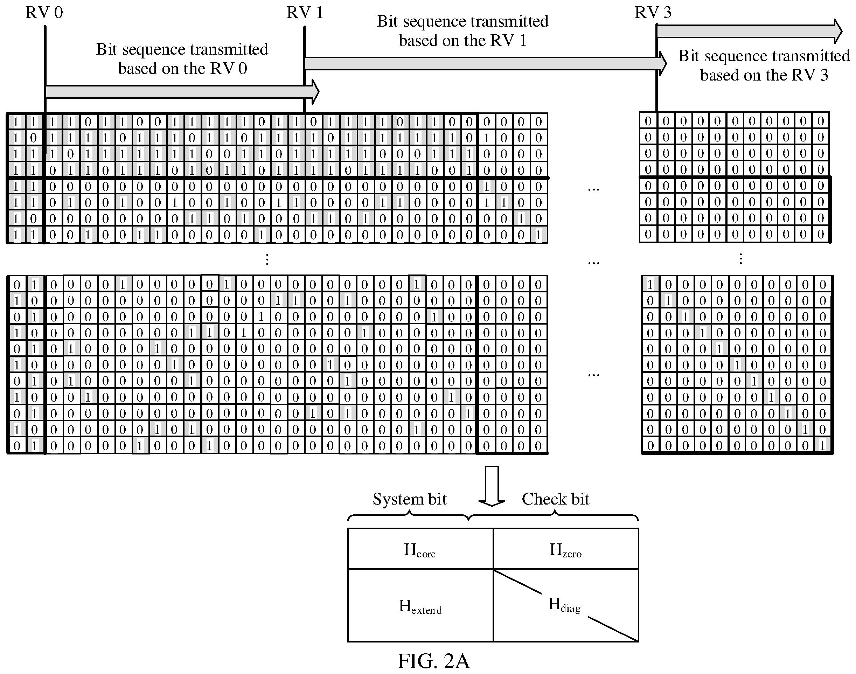

A start location corresponding to an RV is a start location for transmitting a bit sequence. FIG. 2A is a diagram of an RV division method for NR LDPC according to an embodiment of this application. As shown in FIG. 2A, an input information bit is encoded by using a check matrix corresponding to an LDPC code. The check matrix includes:
H_{core}, which is a core matrix, corresponds to a matrix (system bits) in a black box in the upper left corner in the upper part of FIG. 2A and four columns on the right of the matrix, and is used to ensure LDPC decoding performance;
H_{zero}, which is an all-zero matrix, and has a same number of rows as that of H_{core}, where in the upper part of FIG. 2A, an omitted part on the right of H_{core} is also H_{zero};
H_{extend}, which is an extended matrix, is more sparse in comparison with the H_{core} element, and corresponds to a matrix in the lower left corner in the upper part of FIG. 2A; and
H_{diag}, which is a diagonal matrix, where only a diagonal element is "1", and another element is "0", the matrix mainly supports flexible bit rates of the LDPC code, and is truncated from the upper left corner to the lower right corner based on different bit rate requirements, and H_{diag} corresponds to a matrix in the lower right corner in the upper part of FIG. 2A.

A large part of bit sequences preceding in H_{core} corresponds to system bits, and a small part of bit sequences succeeding in H_{core} and a bit sequence of a zero matrix correspond to check bits.

The system bits are an input bit sequence of each encoding structure, and the check bits are a bit sequence obtained through encoding of the system bits, and may be used to check whether an error occurs during transmission of the system bits. Further, error correction may be performed on the system bits based on the check bits.

In some cases, this embodiment of this application further relates to information bits, which are a pre-encoding original bit sequence.

In the 5G NR technology, an additional redundant part (which is a redundant part other than H_{core}, and may be specifically H_{extend}) of the LDPC is extended based on a raptor-like (raptor-like) structure, to facilitate implementation of low-complexity coding. In addition, four RV versions (an RV 0 to an RV 3) are defined for an encoded bit sequence. Data transmission is performed based on (or by using) an RV, that is, a bit sequence that starts from a start location and that ends at an end location is transmitted based on the start location corresponding to the RV. The end location may be indicated based on other information or set by default.

For specific start locations of the RV 0 to the RV 3 of the LDPC, refer to Table 1.

**Table 1 Start locations of RVs of LDPC in 5G NR**

| RV_{id} | *k*₀ | |
|---|---|---|
| | Based graph 1 of the LDPC | Based graph 2 of the LDPC |
| 0 | 0 | 0 |
| 1 | $\left⌊\frac{17 {N}_{cb}}{66 {Z}_{c}}\right⌋ {Z}_{c}$ | $\left⌊\frac{13 {N}_{cb}}{50 {Z}_{c}}\right⌋ {Z}_{c}$ |
| 2 | $\left⌊\frac{33 {N}_{cb}}{66 {Z}_{c}}\right⌋ {Z}_{c}$ | $\left⌊\frac{25 {N}_{cb}}{50 {Z}_{c}}\right⌋ {Z}_{c}$ |
| 3 | $\left⌊\frac{56 {N}_{cb}}{66 {Z}_{c}}\right⌋ {Z}_{c}$ | $\left⌊\frac{43 {N}_{cb}}{50 {Z}_{c}}\right⌋ {Z}_{c}$ |

As shown in Table 1, *N_{cb}* represents a length of the encoded bit sequence, and *Z_{c}* is a size (referred to as a lifting value or an expansion factor) of a submatrix (or a lifting matrix) that constitutes the check matrix of the LDPC code. *k*₀ represents the start location of the RV. In the LDPC in the NR, start locations corresponding to RVs are unequally (non-uniformly) spaced, and the non-uniformly spaced start locations can improve the decoding performance. Table 1 includes the RVs respectively corresponding to the graph 1 (based graph 1, BG 1 for short) of the LDPC and the graph 2 (based graph 2, BG 2 for short) of the LDPC. In the protocol, the BG 1 corresponds to an enhanced mobile broadband (enhanced mobile broadband, eMBB) service, data is longer, and therefore a matrix is larger; and the BG 2 corresponds to an ultra-reliable low-latency communication (ultra-reliable low-latency communication, URLLC) service, data is shorter, and a matrix is smaller. For the LDPC of the BG 1 (a bit length after encoding is 66 *Z_{c}*) and the BG 2 (a bit length after encoding is 50 *Z_{c}*), the start locations corresponding to the RV 0 to the RV 3 are shown in Table 1. When the start location is 0, in some cases, there may be two columns of punctured columns at the beginning. The RV 0 (including all system bits) and the RV 3 have a self-decoding function. In a quasi-cyclic LDPC code design process, design is mainly performed based on initial transmission performance. Therefore, initially transmitted data is preferably transmitted based on the RV 0, and subsequent retransmission is performed in a sequence of the RV 2, the RV 3, and the RV 1.

In FIG. 2A, a bit sequence on which LDPC encoding is performed is used for RV division. Actually, for bit sequences encoded based on other encoding structures, including an RS code, a BCH code, and the like, the encoded bit sequences may be divided into different RVs. Start locations specifically corresponding to RVs of encoded bit sequences of different coupled codes may be different.

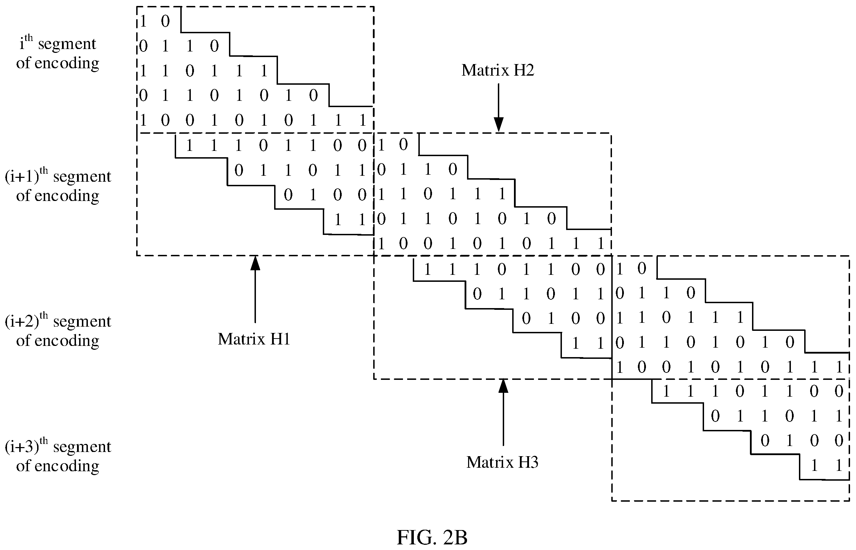

In addition, this embodiment further relates to a coding scheme of a spatially coupled code. The spatially coupled (spatially coupled, SC) code is capacity-approaching coding scheme. The spatially coupled code is used to construct a new codeword by using conventional coupled codes, for example, which are specifically an LDPC code, an RS code, and a BCH code, as component codes for operations such as convolution and superposition. FIG. 2B is a diagram of a spatially coupled code generator matrix according to an embodiment of this application. As shown in FIG. 2B, a spatially coupled code corresponds to the matrix shown in the figure. System bits in an (i+2)^{th} segment of encoding (corresponding to encoding of an (i+2)^{th} component code) include (a part or all of) system bits in an (i+1)^{th} segment of encoding.

The spatially coupled code has become a new research hotspot in academia due to its capacity-approaching feature and appropriate encoding and decoding complexity. An SC-LDPC code is a constructable code proposed on the basis of the LDPC code. In comparison with the LDPC code, the SC-LDPC code has better decoding performance and a simple encoding structure. In theory, the SC-LDPC code can approach the Shannon limit, and a unique syndrome forward encoding scheme and a unique sliding window decoding scheme are used. This effectively reduces encoding and decoding complexity. However, the SC-LDPC code is similar to a product code. Because a large quantity of component codes are split, code lengths of the component codes are short, and code rate adaptation of the SC-LDPC code is difficult to design. Therefore, currently, the SC-LDPC code is mainly applied to fields such as storage and optical communication.

It can be learned from the foregoing description of the conventional technology that, the conventional technology does not provide an RV division design based on structural codes of a plurality of component codes. If RV division, feedback, and retransmission manners of an existing NR protocol are still used, because system bits are not centralized, retransmission performance cannot be well ensured.

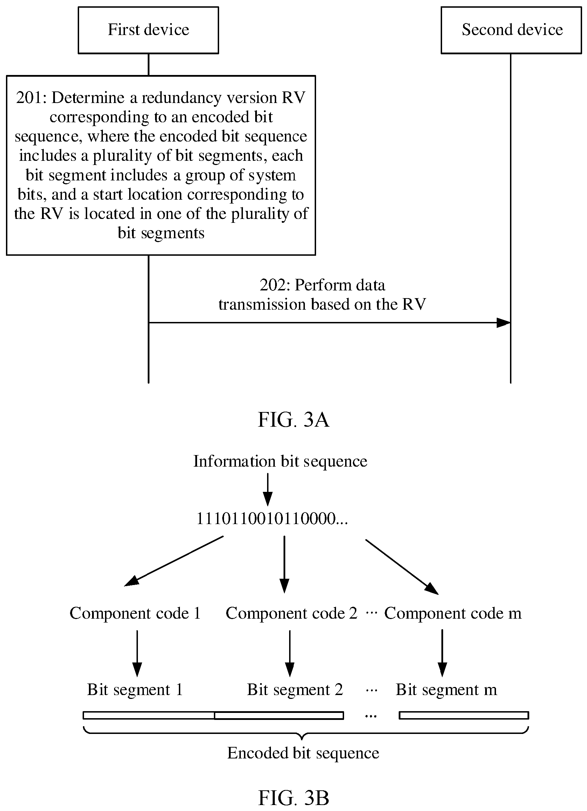

In view of this, an embodiment of this application provides a communication method. Refer to FIG. 3A. The method may include the following steps.

201: A first device determines a redundancy version RV corresponding to an encoded bit sequence, where the encoded bit sequence includes a plurality of bit segments, each bit segment includes a group of system bits, and a start location corresponding to the RV is located in one of the plurality of bit segments.

The first device in this embodiment of this application may be a network device, a UE, or another network element that can perform encoding and communication, for example, a chip that may be used in the network device, or a chip that may be used in a terminal device.

When the first device corresponds to the network device (or a transmission control end in communication between UEs), the RV corresponding to the encoded bit sequence may be determined in either of the following two manners. 1: The first device determines the RV, where for example, the first device may determine all RVs based on a protocol specification or a transmission requirement, and then determine an order of all the RVs, of the encoded bit sequence, used for data transmission, to determine an RV used for current data transmission; or 2: the RV is determined based on received feedback information about whether decoding is correct, where the first device may determine, based on the received feedback information about whether decoding is correct, whether to obtain a next RV for data transmission based on the order of the RVs (in this case, data transmission is not initial transmission, and therefore may also be referred to as data retransmission).

When the first device corresponds to the UE, a manner of determining the RV may be either of the following two manners. 1: The first device determines the RV according to a protocol; or 2: the RV is obtained based on received information. The received information may be, for example, at least one of the following information sent by the network device or a peer UE: configuration information related to RV division, a corresponding RV order during data transmission, feedback information about whether decoding is correct, or a specified target RV corresponding to data transmission.

To-be-sent information bits may be encoded based on an encoding structure (or an encoding matrix) to obtain the encoded bit sequence. The encoding structure in this embodiment of this application includes a plurality of component codes, each component code is encoded to obtain one bit segment, and each bit segment corresponds to a group of system bits and check bits. Alternatively, in some cases, a single bit segment may correspond to only one group of system bits (for example, when a code rate is 1). In the following embodiment, an example in which each bit segment corresponds to the group of system bits and check bits is used for description. It should be understood that a related implementation may also be applied to a scenario in which the bit segment corresponds to only the group of system bits.

The component codes may be of various component code types such as an LDPC code, a BCH code, and an RS code. The component code may be in a form of a generator matrix, for example, in a form of y=G*x, where G represents the generator matrix. Alternatively, the component code may be in a form of a check matrix, for example, in a form of y*H=0, where H represents the check matrix.

FIG. 3B is a diagram of obtaining an encoded bit sequence through encoding according to an embodiment of this application. As shown in FIG. 3B, an information bit sequence is separately encoded based on a component code 1, a component code 2, ..., and a component code m, to obtain a bit segment 1 to a bit segment m, where m is a positive integer greater than 1. Because each group of bit segments (or each bit segment) includes system bits and check bits, one bit segment corresponds to one group of system bits and check bits. For example, a first group of system bits and check bits correspond to a bit segment 1, a second group of system bits and check bits correspond to a bit segment 2, the rest may be deduced by analogy, and an m^{th} group of system bits and check bits correspond to a bit segment m. The bit segments corresponding to the m groups of system bits and check bits form the encoded bit sequence corresponding to the information bits.

Each RV corresponds to one start location. In this embodiment of this application, the start location corresponding to each RV is located in one of a plurality of bit segments of the encoded bit sequence. The start location corresponding to the RV has two meanings: (1) The plurality of bit segments included in the encoded bit sequence are used as a granularity (the start location corresponding to the RV is determined); and (2) one of the plurality of bit segments included in the encoded bit sequence is used as a granularity (the start location corresponding to the RV is determined).

It may be understood that each of the plurality of bit segments may correspond to a group of system bits and check bits. Therefore, using the plurality of bit segments as the granularity may also be referred to as using a plurality of groups of system bits and check bits as the granularity. Using the bit segment as the granularity may also be referred to as using the group of system bits and check bits as the granularity.

It should be understood that a same encoded bit sequence may include both an RV that uses the plurality of groups of system bits and check bits are used as the granularity, and an RV that uses a bit segment of each group of system bits and check bits is used as the granularity.

For the foregoing meaning (1), it is assumed that this type of RV is referred to as a first RV. That the first RV uses the plurality of groups of system bits and check bits as the granularity means that in the plurality of groups of system bits and check bits, the bit segment including each group of system bits and check bits corresponds to one first RV. The bit segment including each group of system bits and check bits may be referred to as each group of bit segments or each bit segment. In this case, an RV corresponding to each group of bit segments (or each bit segment) may correspond to any location in the group of bit segments. A location of a start location corresponding to the RV in the bit segment is not limited in this embodiment of this application.

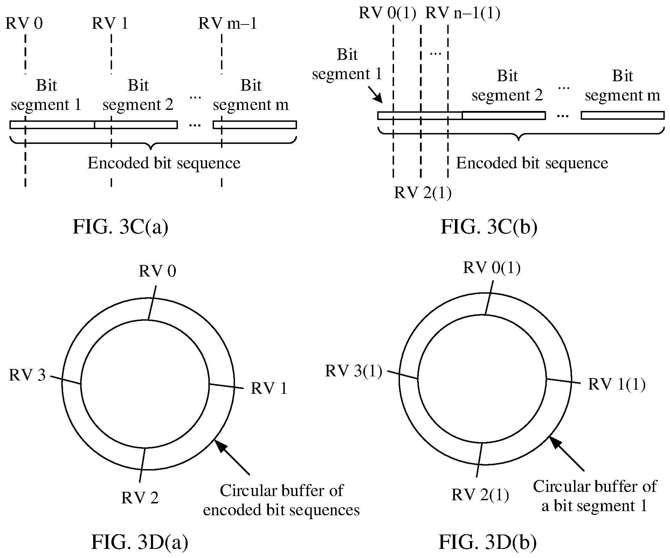

FIG. 3C(a) and FIG. 3C(b) are diagrams of RVs according to an embodiment. As shown in FIG. 3C(a), an encoded bit sequence includes bit segments 1 to m corresponding to m groups of system bits and check bits, each bit segment corresponds to one first RV, and first RVs include an RV 0, an RV 1, ..., and an RV m-1. The RV 0 corresponds to a bit segment 1 (a start location is located in the bit segment 1), the RV 1 corresponds to a bit segment 2, the rest may be deduced by analogy, and the RV m-1 corresponds to a bit segment m. It may be understood that a numbering manner of the RV is not limited in this embodiment of this application.

For example, a start location corresponding to the first RV may be set as the start location of the RV 0 of the LDPC in the foregoing NR. For example, the first RV of the encoded bit sequence is the RV 0. The corresponding start location may be a column 1 of the bit segment 1 or a column 3 (first two columns are punctured columns) of the bit segment 1. Correspondingly, a start location corresponding to another RV may be a column 1 or a column 3 of a bit segment corresponding to the RV, that is, a start location corresponding to the RV m-1 is a column 1 or a column 3 of the bit segment m.

Alternatively, the start location of the first RV may correspond to a column in which system bits are located in each bit segment.

Alternatively, the start location of the first RV may correspond to another column of each bit segment. This is not specifically limited in this embodiment.

For the foregoing meaning (2), it is assumed that this type of RV is referred to as a second RV. That the second RV uses a bit segment of each group of system bits and check bits as the granularity means that the bit segment of each group of system bits and check bits are divided into (one or more) second RVs corresponding to the bit segment of each group of system bits and check bits. In this case, each group of (or each) bit segments may correspond to one or more second RVs.

As shown in FIG. 3C(b), an encoded bit sequence includes a bit segment 1 corresponding to a first group of system bits and check bits. The bit segment 1 is divided into a plurality of second RVs, and specifically includes an RV 0(1), an RV 1(1), ..., and an RV n-1(1). In other words, the bit segment 1 is divided into n second RVs, where n is a value greater than or equal to 1. Another bit segment may also be divided into one or more second RVs corresponding to the another bit segment. For example, a bit segment m may include an RV 0(m), an RV 1(m), and the like.

A start location corresponding to the second RV may alternatively be set in the manner of setting the start location of the RV of the LDPC in the foregoing 5G NR. The bit segment 1 is used as an example. A start location of the RV 0(1) may correspond to a column 1 of the bit segment 1, or a column 3 (first two columns are punctured columns) of the bit segment 1. A start location of the RV 1(1) corresponds to $\left⌊\frac{17 {N}_{cb}}{66 {Z}_{c}}\right⌋ {Z}_{c}$ or $\left⌊\frac{13 {N}_{cb}}{50 {Z}_{c}}\right⌋ {Z}_{c}$, where *N_{cb}* represents a length of the bit segment, *Z_{c}* is a size of a submatrix that constitutes a component code (an encoding structure used to obtain the bit segment through encoding of system bits), and settings of the RV 2(1) and the RV 3(1) are similar to Table 1. It may be understood that a numbering manner of the RV is not limited in this embodiment of this application.

Alternatively, the start location corresponding to the second RV may correspond to another column of each bit segment. This is not specifically limited in this embodiment.

202: The first device performs data transmission based on the RV.

In this embodiment of this application, based on the RV, the start location corresponding to the RV (the start location is a location of a corresponding initial bit in a corresponding circular buffer during data transmission) may be determined, so that data used for transmission includes two meanings: (1) initial transmission and (2) retransmission. Initial transmission indicates that data transmission is performed for a first time on the encoded bit sequence based on the start location corresponding to the RV. Retransmission indicates that data transmission is performed for a subsequent time on the encoded bit sequence based on the start location corresponding to the RV.

That data transmission is performed based on the start location corresponding to the RV is that data transmission starts from a bit of the corresponding start location of the RV. In addition, when the RV in this embodiment of this application is the first RV or the second RV, transmission granularities corresponding to the RVs are also different. In other words, that data transmission is performed based on the start location corresponding to the RV includes two meanings: ① Based on the first RV, at least one bit segment (or at least one group of system bits and check bits, which may be referred to as using the plurality of bit segments or the plurality of groups of system bits and check bits as the transmission granularity) corresponding to the encoded bit sequence is transmitted by using the start location corresponding to the first RV as a start point; and ② based on the second RV, the bit segment (the group of system bits and check bits corresponding to the bit segment, which may be referred to as using the bit segment or the group of system bits and check bits as the transmission granularity) in which the second RV is located is transmitted by using a start location corresponding to the second RV as a start point. An end location (or a corresponding end bit column) of data transmission is not limited.

It may be understood that, when data transmission is performed based on the start location corresponding to the second RV, for each second RV, the group of system bits and check bits are used as the transmission granularity. Because each group of system bits and check bits may include the second RV corresponding to the group of system bits and check bits, when data transmission of the plurality of groups of system bits and check bits is performed based on second RVs of the groups of system bits and check bits, transmission at the granularity of the plurality of groups of system bits and check bits can also be implemented as a whole.

In this embodiment of this application, the first device may perform data transmission based on the start location corresponding to the first RV, or perform data transmission of one or more bit segments based on start locations corresponding to the one or more second RVs; or the first device may perform data transmission based on the start location corresponding to the first RV, and perform data transmission of one or more bit segments based on start locations corresponding to the one or more second RVs. A specific data transmission manner is not limited.

For the meaning ①, for example, the first RV is the RV 1. It is assumed that the start location of the RV 1 corresponds to a column 1 of the bit segment 2. Performing data transmission based on the start location of the RV 1 and the encoded bit sequence means transmitting the encoded bit sequence starting from the column 1 of the bit segment 2.

FIG. 3D(a) and FIG. 3D(b) are diagrams of a circular buffer according to an embodiment of this application. A circular buffer (buffer) of encoded bit sequences is shown in FIG. 3D(a). The entire circular buffer includes all the encoded bit sequences. For example, the encoded bit sequence includes bit segments 1 to 4 obtained by encoding four component codes. Each bit segment corresponds to one first RV, and the encoded bit sequence corresponds to four first RVs, namely, an RV 0 to an RV 3. The RV 0 to the RV 3 marked in FIG. 3D(a) correspond to start locations of the corresponding first RVs in the circular buffer of the encoded bit sequence.

For example, a second RV is an RV 0(1). It is assumed that a start location of the RV 0(1) corresponds to a column 1 of the bit segment 1. Performing data transmission based on the start location of the RV 0(1) and the encoded bit sequence means transmitting, starting from the column 1 of the bit segment 1, a group of system bits and check bits corresponding to the bit segment 1.

A circular buffer of the group of system bits and check bits corresponding to the bit segment 1 is shown in FIG. 3D(b). The entire circular buffer includes all groups of system bits and check bits corresponding to the bit segment 1 (excluding a group of system bits and check bits corresponding to another bit segment). For example, the bit segment 1 corresponds to four second RVs, which are the RV 0(1) to an RV 3(1). The RV 0(1) to the RV 3(1) marked in FIG. 3D(b) correspond to start locations of the corresponding second RVs in the circular buffer of the group of system bits and check bits corresponding to the bit segment 1. It may be understood that each group of bit segments may have a corresponding second RV, and data transmission for all groups of bit segments is similar.

It may be understood that the start location of data transmission is determined based on the RV. Subsequently, a series of processing may be further performed to implement a data transmission process. Specifically, processing such as rate matching, symbol modulation, subcarrier mapping, or digital-to-analog conversion may be included. In the rate matching process, a length of a bit sequence that can be transmitted may be determined based on a time-frequency resource used for data transmission, to determine an end location of a corresponding bit sequence in the circular buffer when data transmission is performed based on the RV. Alternatively, when data transmission is performed based on the RV, an end location of a corresponding bit sequence may alternatively be determined in another manner, for example, specified according to a protocol. This is not specifically limited in this embodiment.

Optionally, in a downlink transmission scenario, that is, a first device is a network device, and a second device at a receive end is a UE. When performing data transmission based on the RV and the encoded bit sequence, the first device may further indicate the RV to the second device, so that the second device performs decoding based on the indicated RV.

It can be learned that, in this embodiment of this application, regardless of the first RV or the second RV, the start location corresponding to the RV is located in one of a plurality of bit segments, so that each group of system bits is associated with at least one RV. In this way, each group of system bits can be transmitted through data transmission performed by a transmit end based on the start location of the RV, so that the receive end decodes each group of system bits to obtain the group of system bits, thereby effectively improving data transmission efficiency. However, for the second RV, the start location of data transmission can be located at the smaller granularity, so that the corresponding RV can be selected more accurately for a bit (segment) with a decoding error to perform data retransmission, thereby improving retransmission performance.

In addition, "performing data transmission" in this embodiment of this application may include but is not limited to preparation for data transmission, or corresponding processing for data transmission.

The foregoing embodiment describes a process of encoding information bits based on component codes to obtain the encoded bit sequence. The following further describes a specific encoding scheme.

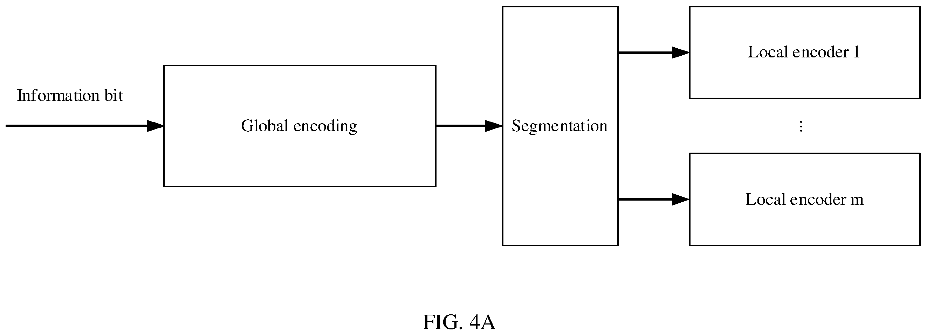

FIG. 4A is a block diagram of an encoding procedure according to an embodiment of this application. As shown in FIG. 4A, the procedure includes the following steps.
(1) A global encoder globally encodes an input information bit sequence, generates redundant check bits, and places the redundant check bits behind a system bit sequence to obtain a globally encoded bit sequence.
(2) The encoded bit sequence obtained through global encoding is segmented, to obtain m globally encoded bit segments.
(3) Each bit segment obtained through global encoding is separately input to a local encoder for local encoding, to obtain m bit segments, where the m bit segments form system bits corresponding to the encoded bit sequence.

In other words, the encoding procedure includes a global encoding process and a local encoding process.

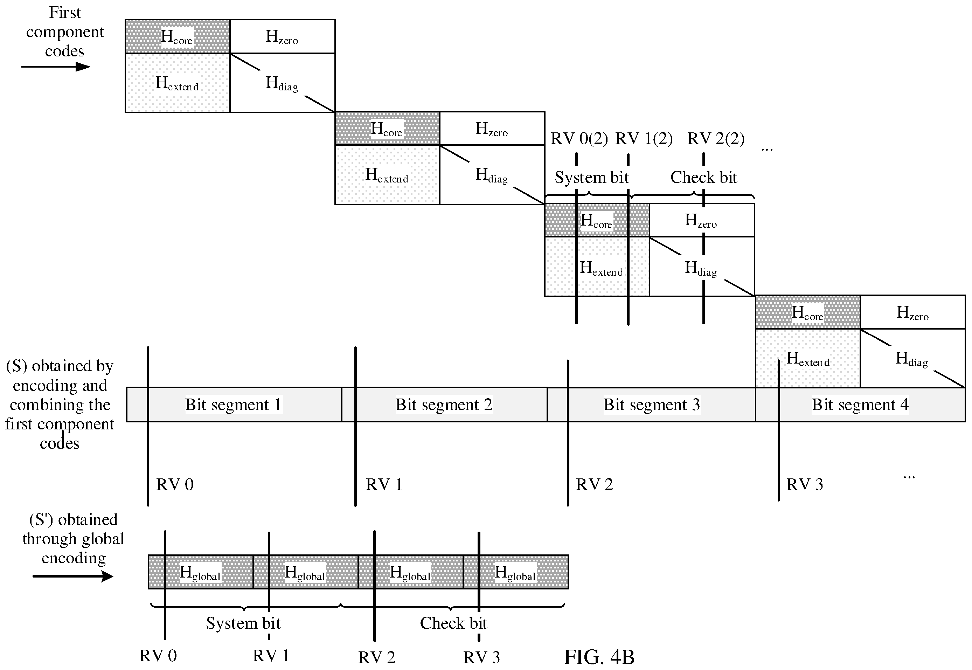

FIG. 4B is a diagram of globally coupled code encoding according to an embodiment of this application. As shown in FIG. 4B, the upper part is that a plurality of bit segments are obtained by separately performing (local) encoding on a plurality of segmented bit sequences based on a plurality of first component codes, including a bit segment 1 to a bit segment 4. The first component codes may be represented by check matrices, and includes H_{core}, H_{zero}, H_{extend}, and H_{diag}. For specific description, refer to the foregoing related description. The plurality of segmented bit sequences do not overlap with each other, that is, submatrices of the first component codes are not correlated with each other. A plurality of groups of system bits and check bits corresponding to the bit segments 1 to 4 form an encoded bit sequence (S).

A start location of each second RV is determined based on a column corresponding to each second RV in each bit segment.

The start location of each first RV may be determined in two manners.
(1) The start location of each first RV is determined based on a length of an encoded bit sequence obtained through local encoding.

A length of each locally encoded bit sequence corresponds to a length of a bit segment. A sum of lengths of a plurality of locally encoded bit sequences is the length of the encoded bit sequence obtained through local encoding, and corresponds to S obtained by encoding and combining the four first component codes in FIG. 4B, where S is used to determine the start location of the first RV. A group of system bits and check bits corresponding to each first RV may be a bit sequence obtained by encoding one first component code.

(2) The start location of each first RV is determined based on a length of a bit sequence obtained through global encoding.

The length of the bit sequence obtained through global encoding corresponds to S' in FIG. 4B. Because the locally encoded bit sequence is re-encoded on the globally encoded bit sequence, the length of the globally encoded bit sequence is shorter than the length of the encoded bit sequence obtained by encoding and combining the first component codes, that is, S'<S. In this case, the plurality of groups of system bits and check bits corresponding to the first RV are a plurality of segmented bit sequences obtained before encoding is performed based on the first component codes. In addition, the segmented bit sequences do not necessarily include both the system bits and the check bits, and may include only the system bits, or may include only the check bits.

In this embodiment, because the encoded bit sequence may be first globally encoded and then obtained through coupling of the plurality of bit sequences obtained by encoding the component codes, an encoding method may be referred to as globally coupled code encoding.

In the globally coupled code encoding scheme, because the matrices of all the first component codes are not correlated, quantities of second RVs corresponding to the plurality of groups of system bits and check bits obtained through encoding based on the plurality of first component codes may be the same, and the quantity of second RVs is greater than 1. In this way, when data transmission is performed on each group of system bits and check bits, a transmission start location can be selected for each group of system bits and check bits at a same granularity. This ensures data transmission flexibility.

Alternatively, quantities of second RVs corresponding to the groups of system bits and check bits may be different, to implement another transmission requirement, for example, a channel requirement or a transmission resource requirement. This is not specifically limited in this embodiment of this application.

The following describes another specific encoding scheme.

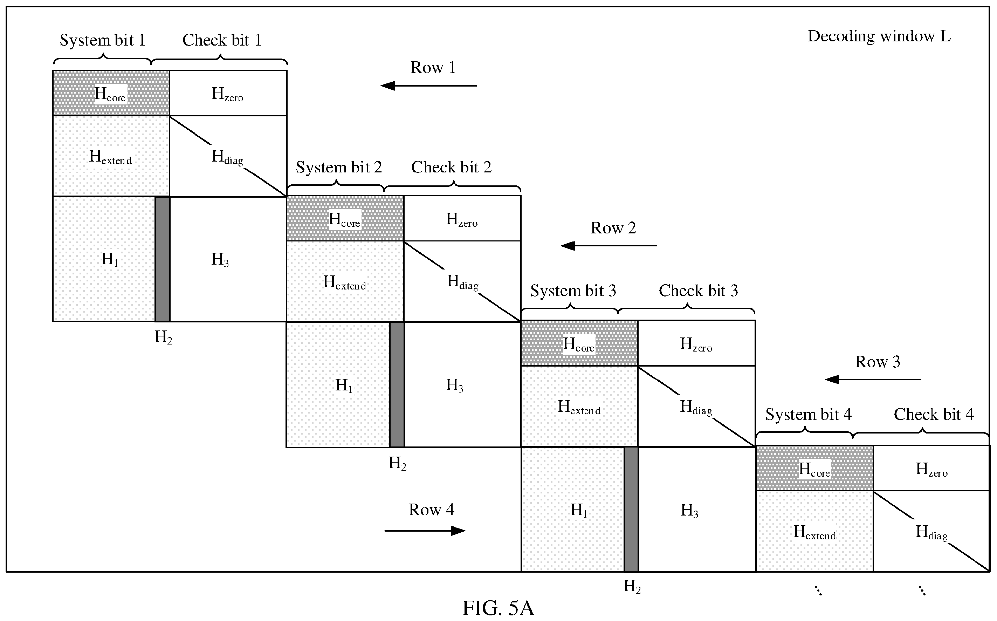

FIG. 5A is a diagram of spatially coupled code encoding according to an embodiment of this application. As shown in FIG. 5A, an example of a check matrix of a spatially coupled code is provided. At a transmit end (which may also be referred to as an encoder side, and is a first device in this embodiment of this application), block convolutional encoding is performed at a granularity of a component code. The component code may be in a form of a generator matrix, or may be in a form of the check matrix. FIG. 5A shows a spatial coupling structure based on the check matrix. Coupling is that a part of rows of check matrices of two adjacent component codes overlap. In correspondence with FIG. 5A, check matrices H1, H2, and H3 corresponding to a row 1 of component codes may overlap with check matrices of a row 2 of component codes. In encoding, a part or all of system bits and/or check bits generated by a previous component code participate in encoding of a next component code. Based on this coupling structure, better encoding performance can be obtained than that of a single component code, which is equivalent to performance of a single component code with a longer code length.

On the encoder side, spatially coupled codes may be infinitely convolutionally encoded like convolutional codes. However, in actual cases, there are few continuous data services. Therefore, an encoding window is generally set at the encoder side, and a spatially coupled code structure is formed in the window. On a decoder side, a decoding window L is usually set in consideration of limitations such as a hardware capability, a processing latency, and storage overheads of a product, where L indicates a maximum quantity of component codes that can be jointly decoded on the decoder side. Therefore, in the foregoing RV design, RV division is also performed based on the encoding window or the decoding window.

In addition, different matrix elements in an overlapping part may correspond to different meanings. For example, the component code is an LDPC code. When H2 and H3 of the overlapping part are not zero matrices, it indicates that redundant bits generated by the previous component code also participate in encoding of the next component code, and coupling is stronger at this time; and when H2 and H3 of the overlapping part are the zero matrices, it indicates that only system bits of the previous component code participate in encoding of the next component code, and coupling is weaker at this time.

In a possible implementation, an encoded bit sequence is generated by encoding a plurality of segmented bit sequences based on a plurality of second component codes respectively, and in the plurality of segmented bit sequences, a segmented bit sequence includes at least a part of system bit sequences in a previous segmented bit sequence.

In this embodiment, the second component codes are used to encode the plurality of segmented bit sequences. During encoding, it is assumed that the previous segmented bit sequence and the segmented bit sequence are included, the segmented bit sequence includes a part or all of system bit sequences of the previous segmented bit sequence, and the next bit sequence may even further include a part of check bit sequences of the previous segmented bit sequence. In the encoded bit sequence generated through encoding in this manner, bit segments corresponding to groups of system bits and check bits obtained by encoding the component codes are spatially coupled to each other. Therefore, this encoding scheme may also be referred to as spatially coupled code encoding.

A first RV and a second RV corresponding to the encoded bit sequence obtained by encoding the spatially coupled codes may also be determined. For a manner of determining the first RV, refer to the foregoing RV 0 division manner of the NR LDPC. For example, a start location of a second RV corresponding to a bit segment 1 of the encoded bit sequence may correspond to a column 1 or a column 3 (first two columns are punctured columns) of the bit segment 1. Correspondingly, a start location corresponding to another RV may be a column 1 or a column 3 of a bit segment corresponding to the RV. It may be understood that the first RV may also correspond to another start location. This is not specifically limited in this embodiment.

A manner of determining the second RV may be performed based on a characteristic of spatially coupled code encoding.

In a possible implementation, in a plurality of bit segments, a quantity of second RVs corresponding to an edge bit segment (corresponding to an edge group of system bits and check bits) is greater than that of a non-edge bit segment (corresponding to a non-edge group of system bits and the check bits), where the edge bit segment is a 1^{st} or last one of the plurality of bit segments. Alternatively, edge bit segments may be first M and/or last N bit segments, where M and N are integers greater than or equal to 1, and M and N may be equal or unequal.

After the plurality of segmented bit sequences of information bits are encoded based on the spatially coupled codes, the encoded bit sequence is obtained, where the encoded bit sequence includes a bit segment corresponding to each of the plurality of groups of system bits and the check bits. A total length of the plurality of groups of system bits and check bits is within a length range of one encoding window.

For example, it is assumed that there are encoding structures of four second component codes in the encoding window. Due to the characteristic of spatially coupled code encoding, check bits generated by an inner component code also include information about system bits or check bits corresponding to an outer component code. In other words, a bit error of the outer component code may be corrected based on the check bits of the inner component code. Therefore, the second RV is defined as *RVi*(*l*), where *l* represents an index value of a second component code in the decoding window, and *i* represents an index value of the second RV in the corresponding second component code. In a possible manner, only a bit segment encoded based on a last second component code corresponds to a plurality of second RVs, and only a 1^{st} second RV, namely, *RV*0(*l*), is defined for bit segments of a plurality of outer second component codes. In this way, retransmission of bit segments of second component codes (the outer second component codes) before the last second component code can ensure that corresponding system bits in a bit segment of each second component code can be retransmitted, and ensure decoding performance and a self-decoding capability of each outer second component code. However, only the bit segment of the last second component code corresponds to more second RVs (incremental redundancy). In this way, the performance can be ensured, low encoding complexity and storage overheads can also be ensured, and large circular buffer storage overheads do not need to be set for the bit segment of each second component code.

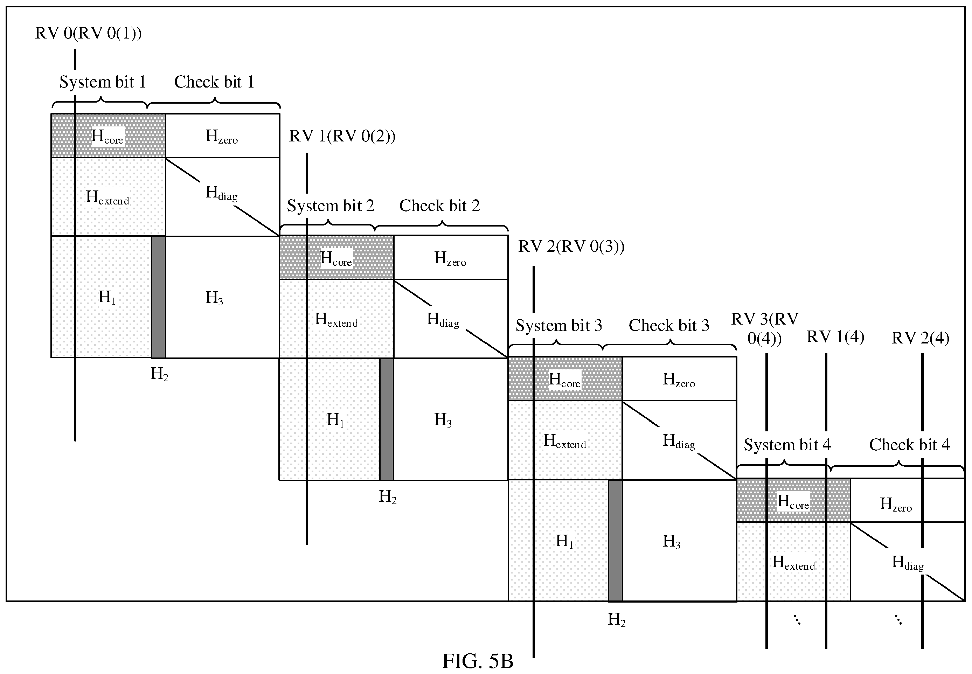

FIG. 5B shows an RV division method for an encoded bit sequence according to an embodiment of this application. As shown in FIG. 5B, a bit segment corresponding to each group of system bits and check bits corresponds to one first RV, a first RV corresponding to a bit segment 1 is an RV 0, a first RV corresponding to a bit segment 2 is an RV 1, the rest may be deduced by analogy, and a first RV corresponding to a bit segment 4 is an RV 3.

In another aspect, each group of system bits and check bits has a second RV corresponding to the group of system bits and check bits, and second RVs corresponding to the bit segments 1 to 3 are: an RV 0(1), an RV 0(2), and an RV 0(3). When a quantity of second RVs of the bit segment is 1, the first RV and the second RV of each bit segment may correspond to a same start location (describing manners may be different, for example, the start location corresponding to the first RV may be described based on a global bit sequence length, and the start location corresponding to the second RV may be described based on a global bit sequence length, or may be described based on a bit sequence length of the bit segment).

The bit segment 4 is a last bit segment in an encoding window L, and corresponds to a largest quantity of second RVs. As shown in FIG. 5B, the second RVs of the bit segment 4 include an RV 0(4), an RV 1(4), and an RV 2(4). The RV 0(4) and a first RV (RV 3) corresponding to the bit segment 4 may correspond to a same start location.

Alternatively, in the encoding window, a plurality of second RVs of incremental redundancy are not set in a bit segment of a last second component code, but are set in a bit segment of a 1^{st} second component code in the encoding window. Due to a convolutional structure of a spatially coupled code, decoding capabilities of a plurality of subsequent second component codes can be enhanced by sending more system bits or check bits in the bit segment of the 1^{st} second component code.

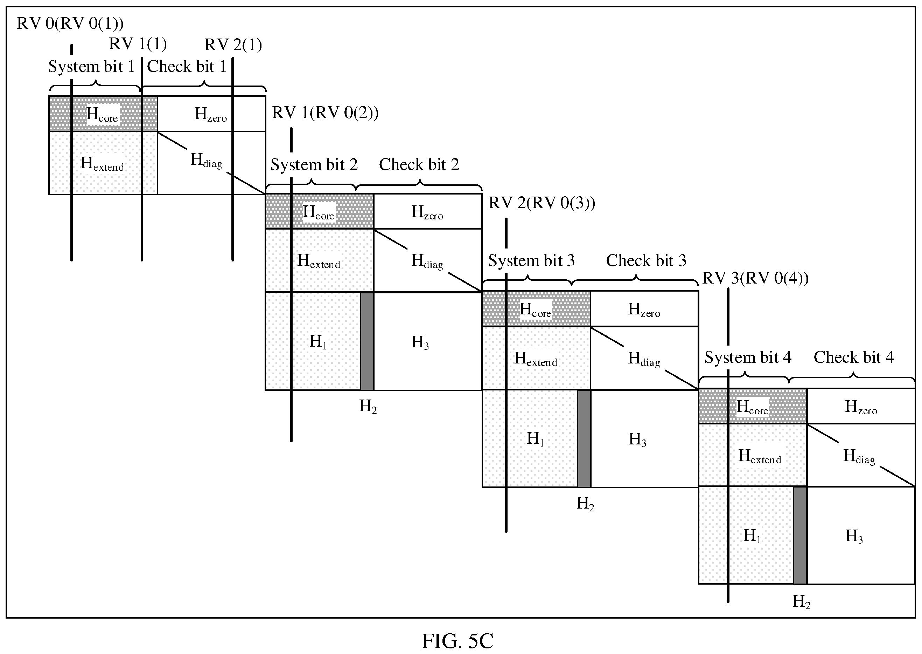

FIG. 5C is a diagram of another RV division method for an encoded bit sequence according to an embodiment of this application. As shown in FIG. 5C, a bit segment corresponding to each group of system bits and check bits corresponds to one first RV, a bit segment 1 corresponds to three second RVs, and bit segments 2 to 4 correspond to one second RV. Similarly, for a bit segment corresponding to one second RV, the second RV and a first RV of the bit segment may correspond to a same start location.

It can be learned that in this embodiment of this application, a plurality of groups of system bits and check bits obtained through spatially coupled code encoding are divided into second RVs. A bit segment of an edge group of system bits and check bits corresponds to more second RVs, and a bit segment of a non-edge group of system bits and check bits corresponds to fewer second RVs. In this way, encoding complexity and storage overheads are reduced while a decoding capability of a second component code is ensured.

The foregoing embodiments describe a process of data transmission based on the RV, where data transmission includes initial transmission and retransmission. The following further describes the retransmission process.

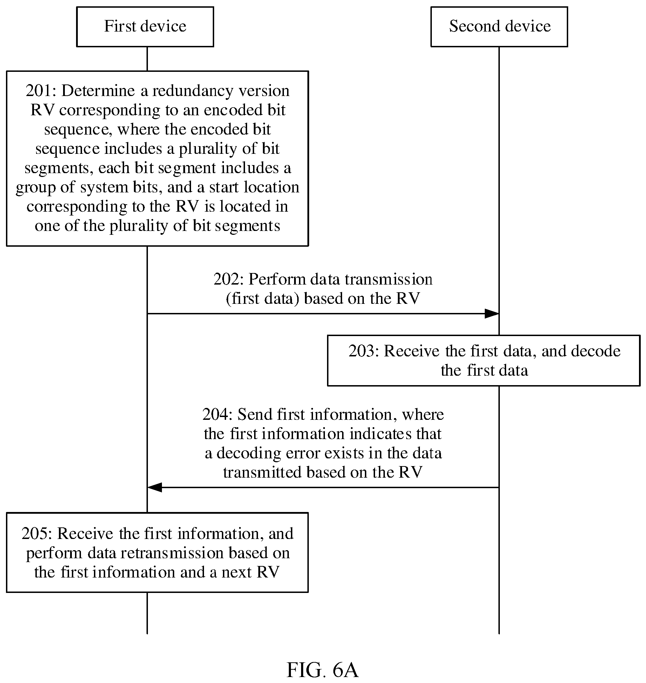

FIG. 6A is a flowchart of another communication method according to an embodiment of this application. The method includes steps 201 and 202 in FIG. 3A, and the method further includes the following steps.

203: A second device receives data transmitted by a first device based on an RV. If data transmission corresponds to first data, the second device decodes the first data.

The first data may be the foregoing encoded bit sequence obtained by the first device, and subsequent further processing such as symbol modulation, multiple-input multiple-output (multiple-input multiple-output, MIMO) precoding, subcarrier mapping, and inverse fast Fourier transform (inverse fast fourier transform, IFFT), is performed, to complete processing on a baseband signal, and obtain the to-be-sent first data.

After receiving the first data, the second device performs reverse processing corresponding to the first device, for example, converts a radio frequency signal of the first data into a baseband signal, and performs FFT, subcarrier demapping, MIMO decoding, symbol demodulation (constellation point demapping), and bit sequence decoding. After symbol demodulation, an obtained to-be-decoded bit sequence and a pre-encoding bit sequence obtained by the first device should be a same bit sequence (which may further include processing soft values of the to-be-decoded bit sequence after symbol demodulation, to obtain hard values, that is, a to-be-decoded bit sequence that does not include floating-point numbers).

Decoding of the first data by the second device is decoding the to-be-decoded bit sequence.

The first data may be sent by the first device based on a first RV and a plurality of groups of system bits and check bits, and may be sent by the first device based on a second RV and one group of system bits and check bits. Therefore, the bit sequence before decoding may correspond to the plurality of groups of system bits and check bits, or may correspond to the group of system bits and check bits.

The second device in this embodiment of this application may be a network device, a UE, or another network element that can perform encoding and communication, for example, a chip that may be used in the network device, or a chip that may be used in a terminal device.

After receiving the first data, the second device decodes the first data, including globally coupled decoding for the foregoing globally coupled encoding, or spatially coupled decoding for the foregoing spatially coupled encoding, to obtain information bits therein.

Specifically, it is assumed that the bit sequence before decoding corresponds to a plurality of groups of system bits and check bits obtained through spatially coupled encoding. A first component code corresponding to each group of system bits and check bits may be used to decode the group of system bits and check bits, to obtain the group of system bits, and then the plurality of groups of system bits are decoded based on a global code, to obtain information bits.

It is assumed that the bit sequence before decoding corresponds to a plurality of groups of system bits and check bits obtained through spatially coupled encoding. A second component code corresponding to each group of system bits and check bits may be used to decode the group of system bits and check bits, to obtain the group of system bits, and the plurality of groups of system bits form information bits.

It may be understood that the foregoing decoding process is merely one possible decoding scheme. This is not limited in this embodiment of this application.

204: The second device sends first information to the first device, where the first information indicates that a decoding error exists in the data transmitted based on the RV.

The decoding error may occur in a process in which the second device decodes the first data. In this case, the second device may send feedback information (the first information) to indicate that the decoding error exists in the data transmitted by the first device (based on the RV), or indicate that data retransmission is needed.

The feedback information is, for example, acknowledgment (Acknowledgment, ACK) information or negative acknowledgment (Negative Acknowledgment, NACK) information. The ACK information indicates that no decoding error exists, and retransmission may not be performed. The NACK information indicates that the decoding error exists and retransmission is needed. In some possible implementations, the feedback information may be determined based on a hybrid automatic repeat request (hybrid automatic repeat request, HARQ) technology.

The feedback information may be indicated based on 1 bit. For example, when the 1 bit is 0, the feedback information corresponds to the ACK information, and when the 1 bit is 1, the feedback information corresponds to the NACK information.

It may be understood that the first device may perform data transmission based on a start location corresponding to the first RV, or perform data transmission of one or more bit segments based on start locations corresponding to one or more second RVs; or the first device may perform data transmission based on a start location corresponding to the first RV, and perform data transmission of one or more bit segments based on start locations corresponding to one or more second RVs. Therefore, when the decoding error exists in the feedback information, the feedback information may be used to feed back a decoding error in data transmission based on the first RV, or may be used to feed back a decoding error in bit segments in any one or more second RVs in data transmission based on the plurality of second RVs. It may also be used to feed back any decoding error in data transmission based on the first RV and the second RV. This is not specifically limited.

For example, it is assumed that the first device performs data transmission based on the first RV (or the second RV). When receiving the 1-bit feedback information sent by the second device, the first device may learn that the decoding error exists in data transmission performed based on the first RV (or the second RV), and retransmission is needed.

It is assumed that the first device performs data transmission based on the first RV and the second RV. When receiving the 1-bit feedback information sent by the second device, the first device determines that the decoding error exists in data transmission based on the first RV and the second RV. The decoding error may exist in data transmission based on the first RV, the decoding error may exist in data transmission based on the second RV, or the decoding error may exist in data transmission based on both the first RV and the second RV. The first device determines, based on the 1-bit feedback information, that data retransmission is needed.

In a possible implementation, because the first device may transmit each bit segment based on a second RV of each bit segment, the second device may send the 1-bit feedback information for each bit segment. Specifically, the first information may include a bitmap, indicating whether the decoding error exists in each bit segment. For example, the first device transmits each of bit segments 1 to 3 based on a start location of a second RV of the bit segment. The bitmap includes 3 bits, and each bit feeds back a decoding result of one bit segment, where 1 indicates that decoding is incorrect, and 0 indicates that decoding is correct. In this case, it is assumed that the bitmap corresponding to the first information is 001. It indicates that the decoding error exists in the bit segment 3, and no decoding error exists in the bit segment 1 or the bit segment 2.

Alternatively, the first information may send the feedback information only for a bit segment with a decoding error, and then indicate the bit segment with a decoding error based on another bit (segment). For example, the first device transmits each of the bit segments 1 to 3 based on the start location of the second RV of the bit segment. If the decoding error exists in the bit segment 2, the first information may include 1-bit NACK information, and also include a 2-bit (corresponding to a quantity of the bit segments being 3) error bit segment indication field. If a value of the 2-bit error bit segment indication field is 11, the first information indicates that the decoding error exists in the bit segment 3.

In addition, the first information corresponds to the bitmap 001. In other words, the first information includes two pieces of ACK information and one piece of NACK information.

The first information may be carried on a physical uplink shared channel (Physical Uplink Shared Channel, PUSCH), or may be carried on a physical downlink shared channel (Physical Downlink Shared Channel, PDSCH), or may be carried on another channel. This is not limited in this embodiment of this application.

205: The first device receives the first information, and performs data retransmission based on the first information and a next RV.

When the first information indicates that the decoding error exists in the data transmitted based on the RV, the first device may perform retransmission based on the first information and the next RV. The next RV is relative to an RV in last transmission, that is, an RV used for current transmission.

Optionally, the first data transmitted last time (which may be initial transmission) may be one of the following two cases: (1) an encoded bit sequence transmitted based on the start location corresponding to the first RV (the following data transmitted based on the first RV refers to that a plurality of bit segments of the encoded bit sequence are used as a transmission granularity); and (2) transmission, based on the start location corresponding to the second RV and the second RV, of a bit segment in which the second RV is located (the following data transmitted based on the second RV refers to that the bit segment in which the second RV is located is used as a transmission granularity).

For case (1), the first data may be retransmitted based on a next first RV. For example, it is assumed that the first data is first transmitted based on an RV 0. A plurality of first RVs may be traversed in a preset order, for example, the preset order is the RV 0, an RV 2, an RV 3, and an RV 1. In this case, the next first RV may be the RV 2, that is, the first data is retransmitted based on the RV 2. Alternatively, a first RV other than the RV 0 may be randomly traversed, and the next first RV may alternatively be the RV 3, that is, the first data is retransmitted based on the RV 3.

For case (2), the first data may be retransmitted based on a next second RV. For example, it is assumed that the first data is first transmitted based on an RV 0(1). The next second RV may be an RV 1(1) (a plurality of second RVs are traversed in a preset order), that is, the first data is retransmitted based on the RV 1(1). Alternatively, the next first RV may be an RV 2(1) (a plurality of second RVs are randomly traversed), that is, the first data is retransmitted based on the RV2 (1).

In a possible implementation, step 205 may be implemented in combination with the foregoing step 201. To be specific, the determining the RV in step 201 is determined based on the first information, and the determining the RV may alternatively be described as determining the next RV. In this case, step 201 to step 205 form a cyclic process.

It can be learned that in this embodiment of this application, the second device indicates, based on the first information, that the decoding error exists in the data transmitted based on the RV, so that the first device determines, based on the first information, whether to retransmit the data based on the next RV. In this process, because each RV corresponds to one group of system bits and check bits, each time of retransmission can correspond to at least one group of system bits, thereby improving retransmission performance. However, for data retransmission of the second RV, a granularity of a retransmitted bit sequence is more accurately divided, so that resource consumption of data retransmission is reduced while the retransmission performance is ensured.

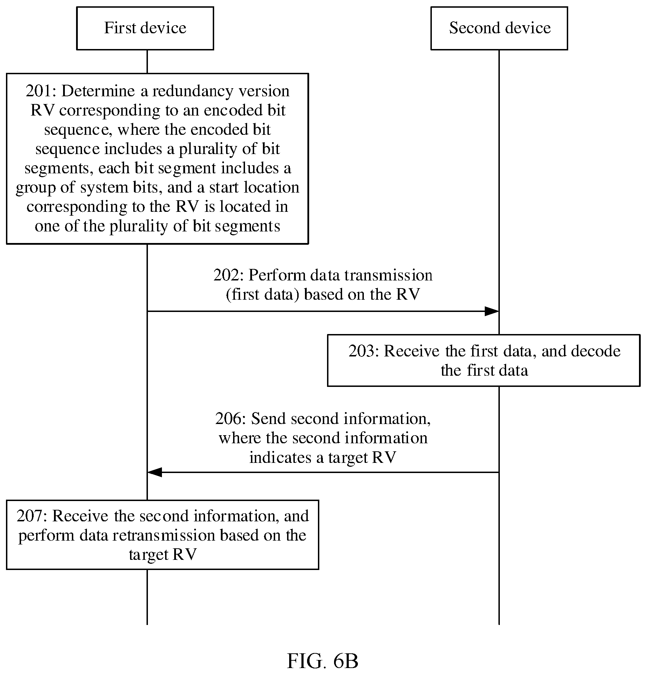

Optionally, FIG. 6B is a flowchart of another communication method according to an embodiment of this application. The method includes steps 201 to 203 in FIG. 6A. The method further includes the following steps.

206: A second device sends second information to a first device, where the second information indicates a target RV.

The second device determines a bit segment with a decoding error, and determines the target RV based on the bit segment with a decoding error. Then, the second device indicates the target RV to the first device, so that the first device performs data transmission based on the target RV.

In this scenario, the first device is a UE, and the second device is a network device. Alternatively, the second device is a UE that is configured to control transmission in communication between UEs.

In other words, after data transmission in 201 to 203, a receive end device indicates the target RV for subsequent data transmission.

There are two cases in which the target RV is determined based on the bit segment with a decoding error.
a. A first RV corresponding to the bit segment with a decoding error is determined as the target RV.

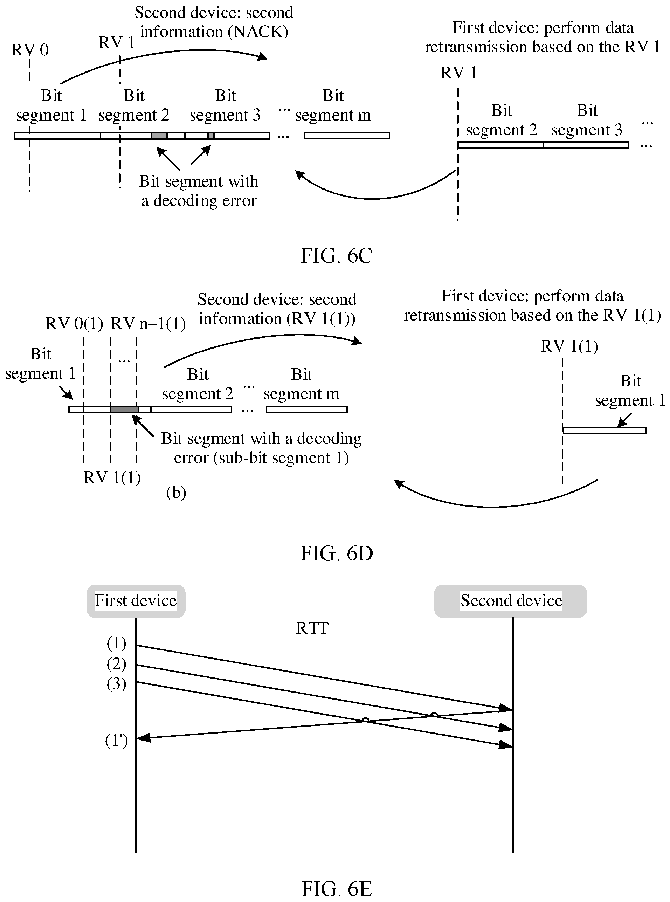

For example, FIG. 6C is a diagram of a process of determining a target RV according to an embodiment of this application. As shown in FIG. 6C, there are a plurality of bits with decoding errors in a bit segment 2, and there are also a few bits with decoding errors in bit segments 3 and 4. It indicates that there are a large quantity of bits with decoding errors that are dispersed. Therefore, a first RV corresponding to the bit segment 2, that is, an RV 1, may be determined as the target RV.

b. A second RV corresponding to the bit with a decoding error in the bit segment with a decoding error is determined as the target RV.

For example, FIG. 6D is a diagram of another process of determining a target RV according to an embodiment of this application. As shown in FIG. 6D, a bit segment with a decoding error is a bit segment 1. Further, it may be located that the bit with a decoding error is a sub-bit segment 1, and the sub-bit segment 1 corresponds to an RV 1(1) of the bit segment 1 (a quantity of bits at a start location corresponding to the RV 1(1) is the smallest). In addition, there is no bit with a decoding error in another bit segment. In the specification, there are a large quantity of bits with decoding errors that are central. Therefore, the target RV is one of second RVs of the bit segment 1.

The target RV determined for the foregoing case a is referred to as a target first RV, and the target RV determined for the foregoing case b is referred to as a target second RV.

In some possible cases, the bits with decoding errors may be central in a bit segment at same time, and are dispersed and arranged in a plurality of bit segments. Therefore, the target RV may alternatively include both the target first RV and the target second RV.

Second information may be carried in DCI, including uplink DCI or downlink DCI. The uplink DCI is control information that is sent by the network device and that is used to schedule a PUSCH, and the downlink DCI is control information indicating a PDSCH-related configuration parameter of the network device.

Specifically, the DCI may include an independent target first RV indication field, where the indication field indicates the target first RV for data retransmission, or include an independent target second RV indication field, where the indication field indicates the second RV corresponding to data retransmission, or
may further include a target RV indication field indicating the target RV, where in combination with an RV granularity indication field, the target RV indication field indicates that the target RV indication field corresponds to the first RV or the second RV.

Optionally, a combination indication field indicating the target first RV and the target second RV that correspond to data retransmission may also be included.

The target second RV indication field may be in a bitmap form, and a second RV of each bit segment corresponds to a part of bits in the bitmap. For example, it is assumed that the bitmap includes 4 bits, and each bit corresponds to a target second RV of one bit segment. When the bitmap is 0010, it indicates that the bit segment 1, the bit segment 2, and a bit segment 4 are retransmitted based on a start location corresponding to an RV 0, and a bit segment 3 is retransmitted based on a start location corresponding to an RV 1. When a larger quantity of second RVs correspond to a bit segment, each bit segment may correspond to more bits in the bitmap.

In addition, in a scenario in which UEs communicate with each other, the second information may be carried in sidelink control information (sidelink control information, SCI).

In some other possible cases, the second information may alternatively be carried in other information. This is not specifically limited in this embodiment of this application.

207: The first device receives the second information, and performs data retransmission based on the target RV.

The first device performs data retransmission based on the target RV and an encoded bit sequence, that is, performs data retransmission based on the target first RV, or performs data retransmission based on the target second RV.

It can be learned that in this embodiment of this application, when determining at least one group of bit segments with decoding errors, the second device may indicate the first device to perform data retransmission based on the target first RV corresponding to the bit segments. Because each RV corresponds to one group of system bits and check bits, each time of retransmission can correspond to at least one group of system bits, thereby improving retransmission performance. In addition, the second device may further determine, based on the bits with decoding errors, to perform data retransmission based on the target second RV of the corresponding bit segment, to indicate the first device to retransmit the bit sequence at a more accurate granularity. This reduces resource consumption of data retransmission while ensuring the retransmission performance.

In a possible implementation, step 207 may be implemented in combination with the foregoing step 201. To be specific, the determining the RV in step 201 is determined based on the second information, and the determining the RV may alternatively be described as determining the next RV. In this case, step 201 to step 207 form a cyclic process.

In a possible case, the method in this embodiment of this application may include step 201 to step 207, and related steps may alternatively be performed in another sequence. The steps in the foregoing method should not constitute a limitation on an implementation of this embodiment of this application.

It may be understood that the implementations corresponding to FIG. 6A to FIG. 6D are applicable to any one of the two encoding schemes proposed in FIG. 4B, FIG. 5A, and FIG. 5B, but are not limited to the foregoing two encoding schemes.

When the decoding error occurs, that the second device indicates the first device to perform data retransmission based on the determined circular buffer and the RV is described in the foregoing process. In some possible cases, for the globally coupled encoding scheme, when receiving the feedback information indicating the decoding error, the first device may also perform the following operations.
(1) When the first device receives the feedback information indicating that the decoding error exists in data transmission that is based on the first RV, it indicates that the bits with decoding errors are dispersed. More check bits may be generated based on a global code check matrix, and correspondingly, more first component code matrices may be obtained through extension, to encode new global check bits in the global code check matrix based on the first component code. Further, more new bit segments are generated, and then more new first RVs corresponding to the new bit segments are obtained through division based on the new bit segments, that is, start locations corresponding to the new first RVs are located in the newly-added bit segments.

When the first device is the network device, data retransmission may be performed based on the new first RVs, to obtain that the retransmitted encoded bit sequence includes fewer bits with decoding errors. In addition, the first device indicates the new first RVs to the UE based on the DCI, so that the UE performs corresponding decoding.

(2) If the first device receives both the feedback information indicating the decoding error in data transmission that is based on the first RV and the feedback information indicating the decoding error in data transmission that is based on the second RV, it indicates that a part of bits with decoding errors are dispersed in the entire encoded bit sequence, and the part of bits with decoding errors are centralized in one or more bit segments.

In this case, the first device determines a first-type bit segment, in the encoded bit sequence, corresponding to a part of system bits in the globally encoded bit sequence (that is, a segmented bit sequence in which the first-type bit segment is encoded is the part of system bits encoded based on the global code), and retransmits the first-type bit segment based on a next second RV of the first-type bit segment. In correspondence with a part of check bits in the globally encoded bit sequence, more new global check bits may be first generated based on the global code check matrix, then the new global check bits are encoded based on the first component code, to generate new bit segments, and then one or more second RVs corresponding to the new bit segments are divided. Finally, second RVs of the new bit segments are used to perform data transmission corresponding to the new bit segments.

According to the foregoing method, more segmented bit sequences can be generated by extending the global code check bits, and more new bit segments can be obtained by encoding the segmented bit sequences based on the first component code, so that a decoding accuracy rate is improved based on data retransmission of the new bit segments, thereby improving the retransmission performance.

In a possible implementation, data transmission of the first device corresponds to a plurality of hybrid automatic repeat request HARQ processes, and before feedback information for one HARQ process is received, a next one of the plurality of HARQ processes is started.

FIG. 6E is a diagram of performing multi-process data transmission by a first device according to an embodiment of this application. As shown in FIG. 6E, the first device performs data transmission by using three HARQ processes (1), (2), and (3), and each HARQ process corresponds to one time of data transmission based on an RV. Round-trip time (round-trip time, RTT) of each HARQ process is greater than a transmission interval of adjacent HARQ processes. To be specific, before receiving feedback information of the HARQ process (1), the first device may simultaneously send the HARQ process (2). In other words, the first device may simultaneously perform data transmission based on a plurality of RVs.

For example, the first device performs data transmission of a bit segment 1 (based on a second RV of the bit segment 1) by using the HARQ process (1), and before receiving feedback information for the bit segment 1, the first device may perform data transmission of a bit segment 2 (based on a second RV of the bit segment 2) by using the HARQ process (2).

According to the method in embodiments of this application, concurrent transmission efficiency of the first device can be further improved.

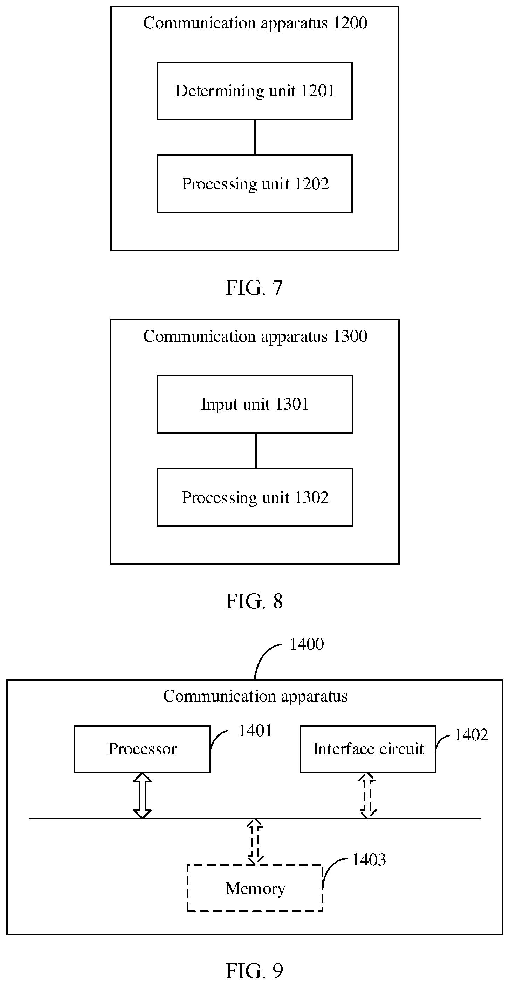

FIG. 7 is a diagram of a structure of a communication apparatus. An implementation of this application further provides a communication apparatus 1200. The communication apparatus 1200 may be a terminal device, or may be an apparatus (for example, a chip or a circuit) used by but not limited to a terminal device, or may be a network device, or may be an apparatus (for example, a chip or a circuit) used by but not limited to a network device. The communication apparatus may include a corresponding module or unit, configured to implement the method or procedure implemented by the first device in the foregoing embodiments. In a possible implementation, the communication apparatus 1200 includes a determining unit 1201 and a processing unit 1202. In a possible implementation,
the determining unit 1201 is configured to determine a redundancy version RV corresponding to an encoded bit sequence. The encoded bit sequence includes a plurality of bit segments, each of the plurality of bit segments includes a system bit, and a start location corresponding to the RV is located in one of the plurality of bit segments.

The processing unit 1202 is configured to perform data transmission based on the RV.

Optionally, the RV includes a first RV, the first RV uses the plurality of bit segments as a granularity, and the performing data transmission based on the RV includes: transmitting, by using a start location corresponding to the first RV as a start point, at least one bit segment corresponding to the encoded bit sequence.

Optionally, the RV includes a second RV, the second RV uses each of the plurality of bit segments as a granularity, and the performing data transmission based on the RV includes: transmitting, by using a start location corresponding to the second RV as a start point, a bit segment in which the second RV is located.

Optionally, the encoded bit sequence is generated through encoding based on a globally coupled code.

Optionally, the encoded bit sequence is generated by encoding a plurality of segmented bit sequences based on a plurality of first component codes respectively, and the plurality of segmented bit sequences do not overlap with each other.

Optionally, the encoded bit sequence is generated through encoding based on a spatially coupled code.

Optionally, the encoded bit sequence is generated by encoding a plurality of segmented bit sequences based on a plurality of second component codes respectively, and in the plurality of segmented bit sequences, a segmented bit sequence includes at least a part of system bit sequences in a previous segmented bit sequence.

Optionally, all bit segments correspond to a same quantity of second RVs that is greater than 1.

Optionally, in the plurality of bit segments, a quantity of second RVs corresponding to an edge bit segment is greater than a quantity of second RVs corresponding to a non-edge bit segment, and the edge bit segment is a 1^{st} or last one of the plurality of bit segments.

Optionally, the processing unit 1202 is further configured to: receive first information, where the first information indicates that a decoding error exists in data transmitted based on the RV; and perform data retransmission the based on the first information and a next RV.

Optionally, the first information includes 1 bit, and when a value of the 1 bit is a first value, it indicates that the decoding error exists in the plurality of bit segments; or the first information includes a bitmap, and the bitmap indicates one or more bit segments in which the decoding error exists in the plurality of bit segments.

Optionally, the first information includes negative acknowledgment NACK information.

Optionally, the processing unit 1202 is further configured to: receive second information, where the second information indicates a target RV; and perform data retransmission based on the target RV.

Optionally, the second information is carried in downlink control information DCI.

It may be understood that, for functions of the modules or units of the communication apparatus 1200, refer to corresponding descriptions in the foregoing method embodiments. Details are not described herein again.

In some possible implementations, the determining unit 1201 and the processing unit 1202 may be deployed on a processor. Optionally, the foregoing units may be combined with a transceiver unit, or include a function of a transceiver unit, to implement the foregoing related methods. The transceiver unit may be deployed in a unit or a module that can implement an information receiving and sending function, for example, a transceiver, a transceiver antenna, or an input/output interface.

In a possible design, when the communication apparatus 1200 is a transmit end device (for example, a terminal device or a network device) or a communication module in a transmit end device, functions of the determining unit 1201 and the processing unit 1202 may be implemented by one or more processors. Specifically, the processor may include a modem chip, or a system on chip SoC chip or an SIP chip including a modem core. A function of the transceiver unit may be implemented by using a transceiver circuit.

In a possible design, when the communication apparatus 1200 is a circuit or a chip that is in a transmit end device (for example, a terminal device or a network device) and that is responsible for a communication function, for example, a modem chip, or a system on chip SoC chip or a SIP chip including a modem core, functions of the determining unit 1201 and the processing unit 1202 may be implemented by a circuit system that includes one or more processors or processor cores in the chip. A function of the transceiver unit may be implemented by using an interface circuit or a data transceiver circuit in the foregoing chip.

FIG. 8 is a diagram of a structure of a communication apparatus. An implementation of this application further provides a communication apparatus 1300. The communication apparatus 1300 may be a terminal device, or may be an apparatus (for example, a chip or a circuit) used by but not limited to a terminal device, or may be a network device, or may be an apparatus (for example, a chip or a circuit) used by but not limited to a network device. The communication apparatus may include a corresponding module or unit, configured to implement the method or procedure implemented by the second device in the foregoing embodiments. In a possible implementation, the communication apparatus 1300 includes an input unit 1301 and a processing unit 1302. In a possible implementation,
the input unit 1301 is configured to receive data transmitted based on an RV. A start location corresponding to the RV is located in a plurality of bit segments included in a bit sequence before decoding, and each bit segment includes a system bit.

The processing unit 1302 is configured to send first information or second information. The first information indicates that a decoding error exists in the data transmitted based on the RV, and the second information indicates a target RV.

In some possible implementations, the RV includes a first RV, and the first RV uses the plurality of bit segments as a granularity.

In some possible implementations, the RV includes a second RV, and the second RV uses each of the plurality of bit segments as a granularity.

In some possible implementations, the bit sequence before decoding is generated through encoding based on a globally coupled code.

In some possible implementations, the bit sequence before decoding is generated by encoding a plurality of segmented bit sequences based on a plurality of first component codes respectively, and the plurality of segmented bit sequences do not overlap with each other.

In some possible implementations, the bit sequence before decoding is generated through encoding based on a spatially coupled code.

In some possible implementations, the bit sequence before decoding is generated by encoding a plurality of segmented bit sequences based on a plurality of second component codes respectively, and in the plurality of segmented bit sequences, a segmented bit sequence includes at least a part of system bit sequences in a previous segmented bit sequence.

In some possible implementations, all bit segments correspond to a same quantity of second RVs that is greater than 1.

In some possible implementations, in the plurality of bit segments, a quantity of second RVs corresponding to an edge bit segment is greater than a quantity of second RVs corresponding to a non-edge bit segment, and the edge bit segment is a 1^{st} or last one of the plurality of bit segments.

In some possible implementations, the first information includes negative acknowledgment NACK information.

In some possible implementations, the second information is carried in downlink control information DCI.

It may be understood that, for functions of the modules or units of the communication apparatus 1300, refer to corresponding descriptions in the foregoing method embodiments. Details are not described herein again.

It may be understood that the processing unit and the input unit may alternatively be implemented by using another hardware circuit, provided that corresponding functions can be implemented. This is not limited in this embodiment of this application. For example, the processing unit may be a decoder or a processor with a decoding function.

In a possible design, when the communication apparatus 1300 is a receive end device (for example, a terminal device or a network device) or a communication module in a receive end device, a function of the processing unit 1302 may be implemented by one or more processors. Specifically, the processor may include a modem chip, or a system on chip SoC chip or an SIP chip including a modem core. A function of the input unit may be implemented by using a transceiver circuit.

In a possible design, when the communication apparatus 1300 is a receive end device (for example, a terminal device or a network device) or a circuit or a chip that is in a receive end device and that is responsible for a communication function, for example, a modem chip, or a system on chip SoC chip or a SIP chip including a modem core, a function of the processing unit 1302 may be implemented by a circuit system that includes one or more processors or processor cores in the chip. A function of the input unit may be implemented by using an interface circuit or a data transceiver circuit in the foregoing chip.

FIG. 9 is a diagram of a hardware structure of a communication apparatus 1400 according to an embodiment of this application. For a structure of the communication apparatus 1200 or the communication apparatus 1300, refer to the structure shown in FIG. 9.

The communication apparatus 1400 includes a processor 1401. Optionally, the communication apparatus 1400 may further include an interface circuit 1402, and the processor 1401 and the interface circuit 1402 are coupled to each other. It may be understood that the interface circuit 1402 may be a transceiver or an input/output interface. Optionally, the communication apparatus 1400 may further include a memory 1403 (represented by dashed lines in the figure). The memory 1403 is configured to: store instructions executed by the processor 1401, or store input data needed by the processor 1401 to run the instructions, or store data generated by running the instructions by the processor 1401.

In an implementation, a function of the interface circuit 1402 may be considered to be implemented by using a transceiver circuit or a transceiver-dedicated chip. The processor 1401 may be implemented by using a dedicated processing chip, a processing circuit, a processor, or a general-purpose chip. The processor may be a central processing unit (central processing unit, CPU), a network processor (network processor, NP), or a combination of a CPU and an NP. The processor may further include a hardware chip or another general-purpose processor. The hardware chip may be an application-specific integrated circuit (application-specific integrated circuit, ASIC), a programmable logic device (programmable logic device, PLD), or a combination thereof. The PLD may be a complex programmable logic device (complex programmable logic device, CPLD), a field programmable gate array (field programmable gate array, FPGA), a generic array logic (generic array logic, GAL) and another programmable logic device, a discrete gate or a transistor logic device, a discrete hardware component, or the like, or any combination thereof. The general-purpose processor may be a microprocessor, or the processor may be any conventional processor or the like.

It may be understood that the memory mentioned in embodiments of this application may be a volatile memory or a non-volatile memory, or may include a volatile memory and a non-volatile memory. The non-volatile memory may be a read-only memory (Read-Only Memory, ROM), a programmable read-only memory (Programmable ROM, PROM), an erasable programmable read-only memory (Erasable PROM, EPROM), an electrically erasable programmable read-only memory (Electrically EPROM, EEPROM), or a flash memory. The volatile memory may be a random access memory (Random Access Memory, RAM), used as an external cache. By way of example but not limitation, a plurality of forms of RAMs may be used, for example, a static random access memory (Static RAM, SRAM), a dynamic random access memory (Dynamic RAM, DRAM), a synchronous dynamic random access memory (Synchronous DRAM, SDRAM), a double data rate synchronous dynamic random access memory (Double Data Rate SDRAM, DDR SDRAM), an enhanced synchronous dynamic random access memory (Enhanced SDRAM, ESDRAM), a synchronous link dynamic random access memory (Synchlink DRAM, SLDRAM), and a direct rambus random access memory (Direct Rambus RAM, DR RAM). It should be noted that the memory described in this application aims to include but is not limited to these memories and any memory of another proper type.

An embodiment of this application provides a computer storage medium, storing a computer program. The computer program includes instructions for performing the method corresponding to the first device or the second device in the foregoing embodiments.

An embodiment of this application provides a computer program product including instructions. When the computer program product runs on a computer, the computer is enabled to perform the method corresponding to the first device or the second device in the foregoing embodiments.

An embodiment of this application provides a communication system. The communication system includes the first device and the second device in the foregoing embodiments.

It should be understood that sequence numbers of the foregoing processes do not mean execution sequences in various embodiments of this application. The execution sequences of the processes should be determined based on functions and internal logic of the processes, and should not be construed as any limitation on the implementation processes of embodiments of this application.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in this application, it should be understood that the disclosed system, apparatus, and method may be implemented in other manners. For example, the described apparatus embodiments are merely examples. For example, division into the units is merely logical function division. There may be another division manner during actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. A part or all of the units may be selected based on actual requirements to achieve the objectives of the solutions of embodiments.

In addition, functional units in embodiments of this application may be integrated into one processing unit, each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, or a network device) to perform all or some of the steps of the methods described in embodiments of this application. The foregoing storage medium includes any medium that can store program code, such as a USB flash drive, a removable hard disk, a read-only memory (Read-Only Memory, ROM), a random access memory (Random Access Memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A communication method, wherein the method comprises:
determining a redundancy version RV corresponding to an encoded bit sequence, wherein the encoded bit sequence comprises a plurality of bit segments, each of the plurality of bit segments comprises a system bit, and a start location corresponding to the RV is located in one of the plurality of bit segments; and
performing data transmission based on the RV.

2. The method according to claim 1, wherein the RV comprises a first RV, the first RV uses the plurality of bit segments as a granularity, and the performing data transmission based on the RV comprises: transmitting, by using a start location corresponding to the first RV as a start point, at least one bit segment corresponding to the encoded bit sequence.

3. The method according to claim 1 or 2, wherein the RV comprises a second RV, the second RV uses the bit segment in the plurality of bit segments as a granularity, and the performing data transmission based on the RV comprises: transmitting, by using a start location corresponding to the second RV as a start point, a bit segment in which the second RV is located.

4. The method according to any one of claims 1 to 3, wherein the encoded bit sequence is generated through encoding based on a globally coupled code.

5. The method according to claim 4, wherein the encoded bit sequence is generated by encoding a plurality of segmented bit sequences based on a plurality of first component codes respectively, and the plurality of segmented bit sequences do not overlap with each other.

6. The method according to any one of claims 1 to 3, wherein the encoded bit sequence is generated through encoding based on a spatially coupled code.

7. The method according to claim 6, wherein the encoded bit sequence is generated by encoding a plurality of segmented bit sequences based on a plurality of second component codes respectively, and in the plurality of segmented bit sequences, a segmented bit sequence comprises at least a part of system bit sequences in a previous segmented bit sequence.

8. The method according to claim 7, wherein in the plurality of bit segments, a quantity of second RVs corresponding to an edge bit segment is greater than a quantity of second RVs corresponding to a non-edge bit segment, and the edge bit segment is a 1^{st} and/or last one of the plurality of bit segments.

9. The method according to any one of claims 1 to 8, further comprising:
receiving first information, wherein the first information indicates that a decoding error exists in data transmitted based on the RV; and
performing data retransmission based on the first information and a next RV.

10. The method according to claim 9, wherein the first information comprises 1 bit, and when a value of the 1 bit is a first value, it indicates that the decoding error exists in the plurality of bit segments; or
the first information comprises a bitmap, and the bitmap indicates one or more bit segments in which the decoding error exists in the plurality of bit segments.

11. The method according to any one of claims 3 to 9, further comprising:
receiving second information, wherein the second information indicates a target RV; and
performing data retransmission based on the target RV.

12. The method according to claim 11, wherein the second information is carried in downlink control information DCI.

13. A communication method, wherein the method comprises:
receiving data transmitted based on an RV, wherein a start location corresponding to the RV is located in a plurality of bit segments comprised in a bit sequence before decoding, and each bit segment comprises a system bit; and
sending first information or second information, wherein the first information indicates that a decoding error exists in the data transmitted based on the RV, and the second information indicates a target RV.

14. The method according to claim 13, wherein the RV comprises a first RV, and the first RV uses the plurality of bit segments as a granularity.

15. The method according to claim 13 or 14, wherein the RV comprises a second RV, and the second RV uses a bit segment in the plurality of bit segments as a granularity.

16. The method according to any one of claims 13 to 15, wherein the bit sequence before decoding is generated through encoding based on a globally coupled code.

17. The method according to claim 16, wherein the bit sequence before decoding is generated by encoding a plurality of segmented bit sequences based on a plurality of first component codes respectively, and the plurality of segmented bit sequences do not overlap with each other.

18. The method according to any one of claims 13 to 15, wherein the bit sequence before decoding is generated through encoding based on a spatially coupled code.

19. The method according to claim 18, wherein the bit sequence before decoding is generated by encoding a plurality of segmented bit sequences based on a plurality of second component codes respectively, and in the plurality of segmented bit sequences, a segmented bit sequence comprises at least a part of system bit sequences in a previous segmented bit sequence.

20. The method according to claim 19, wherein in the plurality of bit segments, a quantity of second RVs corresponding to an edge bit segment is greater than a quantity of second RVs corresponding to a non-edge bit segment, and the edge bit segment is a 1^{st} or last one of the plurality of bit segments.

21. The method according to any one of claims 13 to 20, wherein the second information is carried in downlink control information DCI.

22. A communication apparatus, comprising a unit configured to perform the method according to any one of claims 1 to 12, or comprising a unit configured to perform the method according to any one of claims 13 to 20.

23. A communication apparatus, wherein the communication apparatus comprises a memory and one or more processors, the memory is configured to store a part or all of a necessary computer program or instructions for implementing functions according to any one of claims 1 to 12 or any one of claims 13 to 20, and the one or more processors may execute the computer program or the instructions, to enable the communication apparatus to implement the method according to any one of the possible designs or implementations of claims 1 to 12 or claims 13 to 20 when the computer program or the instructions are executed.

24. A communication system, comprising the communication apparatus according to claim 22 or 23.

25. A computer-readable storage medium, wherein the computer-readable storage medium stores computer instructions, and the computer instructions instruct a communication apparatus to perform the method according to any one of claims 1 to 12, or the computer instructions instruct a communication apparatus to perform the method according to any one of claims 13 to 20.

26. A circuit, comprising a processor and an interface, configured to execute a computer program or instructions stored in a memory, to perform the method according to any one of claims 1 to 12, or perform the method according to any one of claims 13 to 20.

27. A computer program product, wherein the computer program product comprises a computer program, code, or instructions, and when the computer program is run, a computer is enabled to perform the method according to any one of claims 1 to 12, or perform the method according to any one of claims 13 to 20.
